# EUROPÄISCHE PATENTSCHRIFT

(11) **EP 0 591 706 B1**
(45) Veröffentlichungstag und Bekanntmachung des Hinweises auf die Patenterteilung: **24.04.2002**
(21) Anmeldenummer: 93114639.3
(22) Anmeldetag: 11.09.1993
(51) Int. Cl.: C23C 14/56, H01L 21/00

(54) **Kammer für den Transport von Werkstücken**
Chamber for transport of substrates
Enceinte pour le transport des substrats

(30) Priorität: 06.10.1992 CH 311992; 11.03.1993 CH 75793
(43) Veröffentlichungstag der Anmeldung: 13.04.1994
(60) Teilanmeldung: 01119538.5
(73) Patentinhaber: Unaxis Balzers Aktiengesellschaft, 9496 Balzers (LI)
(72) Erfinder: Schertler, Roman, A-6922 Wolfurt (AT)
(74) Vertreter: Troesch Scheidegger Werner AG

(56) Entgegenhaltungen:
- EP-A- 0 136 526
- EP-A- 0 518 109
- GB-A- 2 120 627
- PATENT ABSTRACTS OF JAPAN vol. 10, no. 107 (C-341)(2164) 22. April 1986 & JP-A-60 238 479 (NICHIDEN ANELVA KK) 27. November 1985

## Beschreibung

Die vorliegende Erfindung betrifft Vakuumkammern nach Anspruch 1, 2 oder 3, eine Vakuumkammeranordnung nach Anspruch 13 sowie Transportverfahren nach den Ansprüchen 18 bzw. 21.

Für den Transport von Werkstücken, insbesondere von Speicherplatten, wie von CD's, von Magnet- oder magneto-optischen Speicherplatten, in einer Kammer einer Vakuumbehandlungsanlage, wie für die Behandlung der Werkstücke durch reaktive oder nicht reaktive Vakuumprozesse, z.B. durch Aetzverfahren, physikalische oder chemische Beschichtungsverfahren mit oder ohne Glimmentladungsunterstützung, ist es seit langem bekannt, eine Mehrzahl gemeinsam um eine Achse herum in Ausrichtung zu vorgesehenen Aussenöffnungen der Kammer drehbare Werkstückaufnahmen vorzusehen, wozu beispielsweise auf die US-PS 3 856 654 oder auf die DE-PS 24 54 544 verwiesen werden kann.

Gemäss der US-PS 3 856 654 ist es bekannt, rahmenartige Werkstückaufnahmen in der Kammer karussellartig um eine Achse herum zu drehen. Ist ein Rahmen mit dem Werkstück in Ausrichtposition mit der Aussenöffnung der Kammer, woran eine Arbeitsstation angebracht ist, angelangt, so wird, mit einem drehachsparallel wirkenden Huborgan, das Werkstück in Bearbeitungsposition geschoben. Es ergab sich ein dreidimensionaler Verschiebungsweg für die Werkstücke, nämlich in zwei Dimensionen gemäss der Karusselldrehebene und in einer dritten, parallel zur Karusselldrehachse aus der Kammer hinaus.

Die DE-PS 24 54 544 schlägt eine Konfiguration vor, bei welcher der Verschiebungsweg in der dritten Dimension massgeblich verringert ist; um eine kompaktere Anlagenbauweise zu erzielen. Hierzu werden die Werkstücke in Bearbeitungsposition nur geringfügig achsparallel verschoben, im Rahmen der Federung, mit welcher Werkstückaufnahmerahmen am Drehkarussell in Achsrichtung verschieblich gelagert sind. Hierzu greift ein Stössel, welcher auf die jeweilige Aussenöffnung mit Bearbeitungsstation ausgerichtet montiert ist, auf den Werkstückhalterungsrahmen, der Bearbeitungskammer gegenüberliegend, ein. Damit wird die Wandung der an die Aussenöffnung der Kammer montierten Behandlungsstation durch einen mit dem Karussell drehenden Teil vervollständigt.

Dieses Prinzip wird auch bei Anlagen gemäss der DE-OS 39 12 295, 40 09 603, 37 16 498 und der EP-A 0 389 820 weiter verfolgt, in teilweise konstruktiven Varianten.

Bei den Fertigungsverfahren, insbesondere der genannten kreisscheibenförmigen Werkstücke, tritt aber immer mehr die Notwendigkeit auf, eine Vielzahl einzelner Bearbeitungsschritte an einer entsprechenden Anzahl von Bearbeitungsstationen vorzunehmen. Das Vorgehen, bei welchem die Werkstücke in Bearbeitungsposition nur minimal aus der Transportebene des Werkstückhalterungskarussells angehoben wurden, kann in diesem Falle nur bedingt weiter helfen, weil der zur Verfügung stehende Platz an der Kammer mit dem Karussell beschränkt ist.

Aus der EP 0 136 562 ist eine Vakuumkammer bekannt, bei welcher eine karussellartige Werktstücktransporteinrichtung Werkstückhalterungen trägt. Die karussellartige Werktstücktransporteinrichtung ist um eine Drehachse getrieben drehbar. Damit sind Werkstücke an den Werkstückhalterungen auf bezüglich der Drehachse der Werkstücktransporteinrichtung radial ausgerichtete Öffnungen in der Kammerwand ausrichtbar. Innerhalb der als Karussell ausgebildeten Werkstücktransporteinrichtung ist eine Vorschubeinrichtung vorgesehen mit bezüglich der erwähnten Drehachse radial ausfahrbaren und rückholbaren, stösselartigen Vorschuborganen, welche drehfest auf die erwähnten Öffnungen ausgerichtet sind. Mittels eines zentrisch wirkenden Keilvorschubes werden alle vorgesehenen Vorschuborgane gegen die Öffnungen hin bzw. von den Öffnungen rückbewegt. Sind alle vorgesehenen Werkstückhalterungen und damit die Werkstücke auf Öffnungen ausgerichtet, was mit Hilfe der karussellartigen Werkstücktransporteinrichtung erfolgt, so werden, synchron, alle Vorschubeinrichtungen nach aussen getrieben, wodurch die Werkstücke von der karussellartigen Werkstücktransporteinrichtung gegen die Öffnungen hin bewegt werden. Umgekehrt werden sie von den Öffnungen rückgeholt.

Es ist Aufgabe der vorliegenden Erfindung, Vakuumkammern mit einer um eine Drehachse drehbar angetriebenen Werkstücktransporteinrichtung vorzuschlagen, mit wesentlich erhöhter Einsatzflexibilität. Ausgehend von einer Vakuumkammer mit einer drehbar angetriebenen, als Karussell ausgebildeten Werkstück-Transporteinrichtung wird dies bei ihrer Ausbildung nach dem Wortlaut von Anspruch 1 erreicht.

An einer Vakuumkammer, welche grundsätzlich eine Werkstücktransporteinrichtung umfasst, die in der Kammer um eine Drehachse drehbeweglich gelagert ist und mindestens zwei Werkstückhalterungen trägt, wird dies bei Ausbildung nach dem Wortlaut von Anspruch 3 erreicht.

Es wird auf die EP 0 518 109 verwiesen, welche Stand der Technik nach Art. 54(3) bildet.

Bei der Vakuumkammer nach dem Wortlaut von Anspruch 3 wird die bei der Kammer nach der EP 0 518 109 bereits erreichte hohe Einsatzflexibilität konsequent ausgenützt, durch Kombination mit einer weiteren Kammer, welche eine Werkstücktransportanordnung aufweist.

Bei Vorgehen nach Anspruch 1 werden zusätzlich zu der Mehrzahl gemeinsam und mit der Werkstücktransporteinrichtung um eine Achse drehbar gelagerter Werkstückhalterungen - am Karussell - mindestens zwei radial zur erwähnten Achse gesteuert ausfahrbare bzw. rückholbare Vorschuborgane vorgesehen, welche in der Kammer, bezüglich des Karussells, unabhängig gelagert sind. Dadurch wird ermöglicht, an vorgegebenen Drehpositionen, nämlich wenn eine Werkstückhalterung am Karussell auf eine der zu bedienenden Öffnungen der Kammer ausgerichtet ist, das Werkstück radial hin oder her zu fördern, mit den Gegebenheiten entsprechend wählbarem Hub, so dass ab dem Karussell die Werkstücke durch die Aussenöffnungen gefördert werden können, und trotzdem, bei nur radialer Bewegung, die Förderweg-Zweidimensionalität voll erhalten bleibt. Da der Karusselldurchmesser durch Grösse und vor allem Anzahl seiner Werkstückaufnahmen gegeben ist, und die Axialausdehnung der Kammer diese mögliche Anzahl nicht beeinflusst, wird erfindungsgemäss auch der Hub der Vorschuborgane in eine Ebene der Kammer gelegt. Damit steht ohne Vergrösserung der Kammer Platz für einen langen Transporthub zur Verfügung.

Unter einem zweiten Aspekt der Erfindung wurde erkannt, dass ein weiterer Nachteil der vorbekannten Karusseltransporttechniken gemäss der EP 0 136 562 ist, dass zusätzliche Organe an der Kammer vorgesehen werden, um, wenn auch teilweise geringfügig, die Werkstücke aus dem Karussell gegen die jeweiligen Öffnungen hin zu fördern. Das Vorsehen solcher zusätzlicher Organe steht insbesondere einer flexiblen, bedürfnisspezifischen Konzeption von Anlagen in unterschiedlicher Konfiguration dadurch entgegen, dass die Wechselwirkung von Karussell und den zusätzlichen Organen auf die jeweilige Kammerkonfiguration mit ihren spezifisch vorgesehenen Aussenöffnungen abgestellt ist.

Wird beispielsweise in einer solchen Anlagenkonfiguration die eine der vorgesehenen Aussenöffnungen nicht mit einer Bearbeitungsstation bestückt, sondern mit einem Deckel verschlossen, so ist trotzdem, dieser Öffnung zugeordnet, ein Vorschuborgan vorzusehen, um in einer anderen Anlagenkonfiguration dieselbe Kammer einsetzen zu können.

Unter diesem Aspekt wird aufgabengemäss die geforderte hohe Einsatzflexibilität bei Ausbildung der Vakuumkammer nach Anspruch 2 erreicht.

Wieder sei auf die vorerwähnte, Stand der Technik nach Art. 54(3) EPÜ bildende EP 0 518 109 hingewiesen.

Es wird dort eine Kammer beschrieben, bei der die Werkstückhalterungen an einer Werkstücktransporteinrichtung angeordnet sind, welche als Ganzes um die Achse getrieben drehbeweglich gelagert ist, und an der zudem, bezüglich dieser Achse, die Werkstücke mittels Vorschubantriebes linear ausfahrbar bzw. rückholbar sind. Damit kann die Kompaktheit derartiger Behandlungsanlagen stark erhöht werden, wobei auch der konstruktive Freiheitsgrad wesentlich erhöht wird.

Auch mit Blick auf die vorerwähnte, Stand der Technik nach Art. 54(3) bildende EP 0 518 109 wird aber beim Vorgehen nach Anspruch 2 durch Kombination mit einer weiteren Kammer mit einer eigenen Werkstücktransportanordnung die erwähnte Einsatzflexibilität konsequent weiter genutzt.

In einer bevorzugten Kammerkombination nach Anspruch 4 wird als weitere Kammer eine Kammer gemäss Anspruch 1 vorgesehen, d.h. eine Kammer mit Karussell als Werkstücktransporteinrichtung und davon unabhängig gelagerten, radial betätigbaren Vorschuborganen.

Bei der letzterwähnten Kammer - der "Karussellkammer" - sei sie für sich betrachtet oder in der eben erwähnten Kombination, wird, dem Wortlaut von Anspruch 6 folgend, vorzugsweise vorgeschlagen, dass die bezüglich der Mehrzahl drehbarer Werkstückhalterungen unabhängig gelagerten Vorschuborgane drehfest in der Kammer gelagert sind. Es ist aber durchaus möglich, auch diese Vorschuborgane bezüglich der Achse des Karussells, aber von letzterem unabhängig, drehbar anzuordnen, womit mit beispielsweise einem solchen Vorschuborgan mehrere Aussenöffnungen bedient werden können, wogegen in der bevorzugten Ausführungsform nach Anspruch 6 jeder damit zu bedienenden Aussenöffnung ein drehfest gelagertes Vorschuborgan zuzuordnen ist.

An den Kammern wird weiter durch Vorgehen nach Anspruch 7 erreicht, dass ein Werkstück, welches hin gegen eine Bearbeitung durch die Kammer durchläuft, dann von der Bearbeitung durch die Kammer wieder zurückläuft, beim Hinweg wesentlich länger in der Kammer verweilt als beim Rückweg. Dadurch wird in der Kammer eine Konditionierung der Werkstücke vor ihrer Bearbeitung möglich, wie ein Entgasen, wozu beispielsweise die erwähnte Kammer durchaus beheizt werden kann oder ein anderes Vorbehandlungsverfahren eingesetzt werden kann.

In bevorzugter Art und Weise eignet sich hierfür vor allem die Kammer mit dem Karussell als Werkstücktransporteinrichtung, weil hier am Karussell eine wesentlich höhere Anzahl Werkstückaufnahmen vorgesehen werden kann als an der Kammer, bei der an der Werkstücktransporteinrichtung auch ein Vorschubantrieb gelagert ist.

Die Vergrösserung des Karussells ist lediglich eine Frage der Kammerausdehnung, während das Vervielfachen der dreh- und linearbeweglichen Organe eine starke Erhöhung der Kammerkomplexität ergibt.

Es wird, dem Wortlaut von Anspruch 8 folgend, vorgezogen, dass der mindestens eine Vorschubantrieb zur zugehörigen Drehachse rechtwinklig ausfahrbar bzw. rückholbar gestaltet wird. Damit wird Zweidimensionalität des Transportweges konsequent beibehalten, zusätzlich zum zweidimensionalen Transportweg der Werkstücktransporteinrichtung.

Die erwähnten Kammern sind weiter bevorzugterweise nach dem Wortlaut von Anspruch 9 ausgebildet.

In einer weiter bevorzugten Variante nach Anspruch 10 wird dabei mindestens ein Teil der Aussenöffnungen dicht, vorzugsweise vakuumdicht, schliessbar ausgebildet.

Bei der Kammer mit Karussell wird dies durch das mindestens eine radial ausfahrbare und rückholbare Vorschuborgan realisiert, ansonsten durch das drehbeweglich und linear verschiebliche Vorschuborgan bzw. den Vorschubantrieb.

Je nach Anforderung an die atmosphärische Entkopplung der beiden Kammern kann eine Dichtung durch eine Spaltdichtung im Sinne einer Druckstufe genügen, oder es werden die beiden Atmosphären vakuumdicht getrennt.

Eine erfindungsgemässe Vakuumkammeranordnung zeichnet sich nach dem Wortlaut von Anspruch 13 aus.

Ein Transportverfahren für Werkstücke in einer evakuierbaren Kammer, bei der mindestens zwei Werkstücke mittels eines ersten Organs um eine Drehachse in einer Drehebene gedreht werden, ist aus der GB-A-2 120 627 bekannt. Werkstücke werden dabei mittels eines Karussells um eine Drehachse in einer Drehebene gedreht. An die Kammer sind Ein-/Ausschleusorgane angekoppelt. Die Werkstücke werden mit Bezug auf die Drehbahn der Werkstücke von aussen zu dem erwähnten Karussell hin transportiert bzw. von diesem nach aussen weg transportiert.

Gemäss dem Kennzeichen von Anspruch 18 wird die erwähnte Aufgabe ausgehend vom erwähnten Verfahren dadurch gelöst, dass die Werkstücke in der ersten Kammer unabhängig voneinander, aus dem Zentrum ihrer Drehbewegung heraus realisiert, gesteuert verschoben werden und durch diese voneinander unabhängige Verschiebung der zweiten Kammer zugeführt oder von ihr rückgeholt werden bzw., dem Wortlaut des Kennzeichens von Anspruch 21 folgend, dadurch, dass die Werkstücke mittels eines zweiten Organs, das unabhängig vom ersten um die Achse drehbar ist oder diesbezüglich drehfest ist, aus dem Zentrum ihrer Drehbewegung heraus realisiert unabhängig voneinander verschoben werden.

Bevorzugte Ausführungsvarianten dieser erfindungsgemässen Verfahren zeichnen sich nach dem Wortlaut der Ansprüche 19 und 20 bzw. nach den Ansprüchen 22 und 23 aus.

Die Erfindung wird anschliessend beispielsweise anhand von Figuren erläutert.

Es zeigen:
- Fig. 1: schematisch einen Längsschnitt durch eine bevorzugte Anlagenkonfiguration, woran die Erfindung unter ihren beiden Aspekten realisiert ist,
- Fig. 2: eine teilweise geschnittene Aufsicht auf eine Anlage gemäss Fig. 1,
- Fig. 2a: eine bevorzugte Ausführungsvariante einer an einer Kammer an der Anlage gemäss den Fig. 1 und 2 vorgesehenen Werkstückaufnahme, bzw. Werkstückhalterung,
- Fig. 3a - 3f: schematisch das Prinzip der Maskierung in bevorzugter Realisation,
- Fig. 4: den Uebergabebereich für Werkstücke mit Maskierungsorganen an einer Anlage gemäss den Fig. 1 bzw. 2 in einer weiteren Ausführungsform,
- Fig. 5: schematisch das Grundprinzip der Maskierung,
- Fig. 6: schematisch und teilweise geschnitten eine erfindungsgemässe Kammer, wie sie an der Anlage gemäss den Fig. 1 und 2 verwendet wird, zur Erläuterung des Grundprinzips der Erfindung unter einem ihrer Aspekte,
- Fig. 7: eine erfindungsgemässe Kammer analog zu der in Fig. 6 dargestellten als weitere Variante,
- Fig. 8: teilweise geschnitten, eine weitere Realisationsform der erfindüngsgemässen Kammerkombination, wie sie auch an der Anlage gemäss den Fig. 1 und 2 in abgewandelter Form realisiert ist,
- Fig. 9: prinzipiell die Kammerkombination gemäss Fig. 8 in einer weiteren Realisationsform,
- Fig. 10: in Aufsicht und teilweise geschnitten, eine erfindungsgemässe Kombination gemäss Fig. 9,
- Fig. 11: schematisch das Grundprinzip der Kombination gemäss den Fig. 8 bis 10 bzw. gemäss den Fig. 1 und 2,
- Fig. 12: ausgehend von einer Kombination nach Fig. 11 schematisch eine weitere Weiterentwicklungsvariante,
- Fig. 13: ausgehend von der Variante der Kammerkombination nach Fig. 12 eine Weiterentwicklung,
- Fig. 14: teilweise geschnitten eine weitere Realisationsform einer Kammer für eine erfindungsgemässe Kombination,
- Fig. 15: die Definition von graphischen Symbolen für verschiedene Kammertypen,
- Fig. 16: beispielsweise Anlagekonfigurationen bzw. Kammerkombinationen mit jeweils mindestens einer der Kammern, dem Prinzip der Kammern gemäss Fig. 1 und 2 folgend, modular aufgebaut,
- Fig. 17: schematisch die Aufsicht auf eine weitere bevorzugte Anlagekonfiguration, modular aufgebaut,
- Fig. 18: schematisch die Seitenansicht der Anlage in der Konfiguration nach Fig. 17.

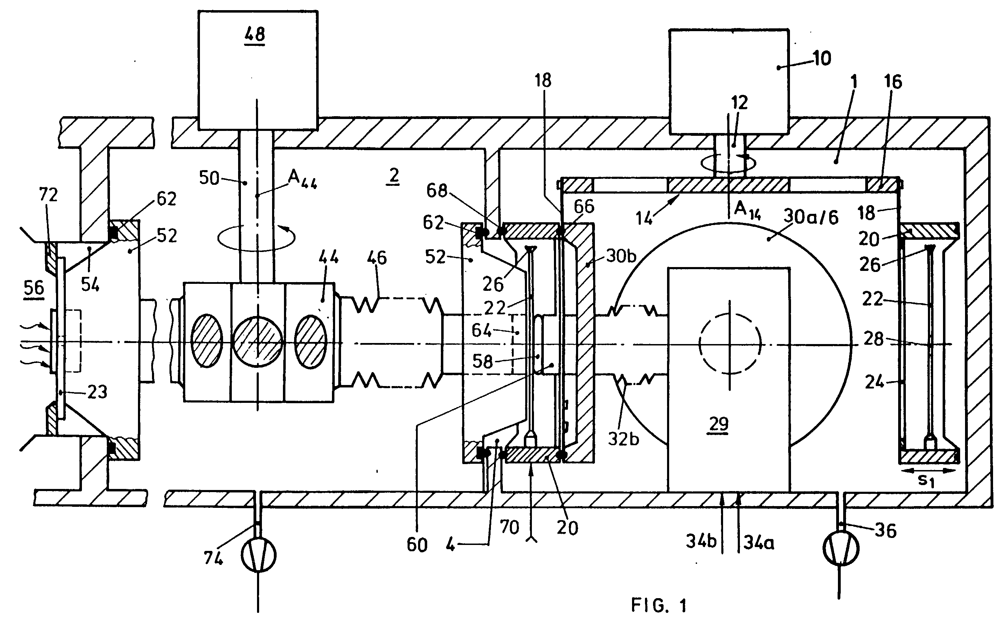

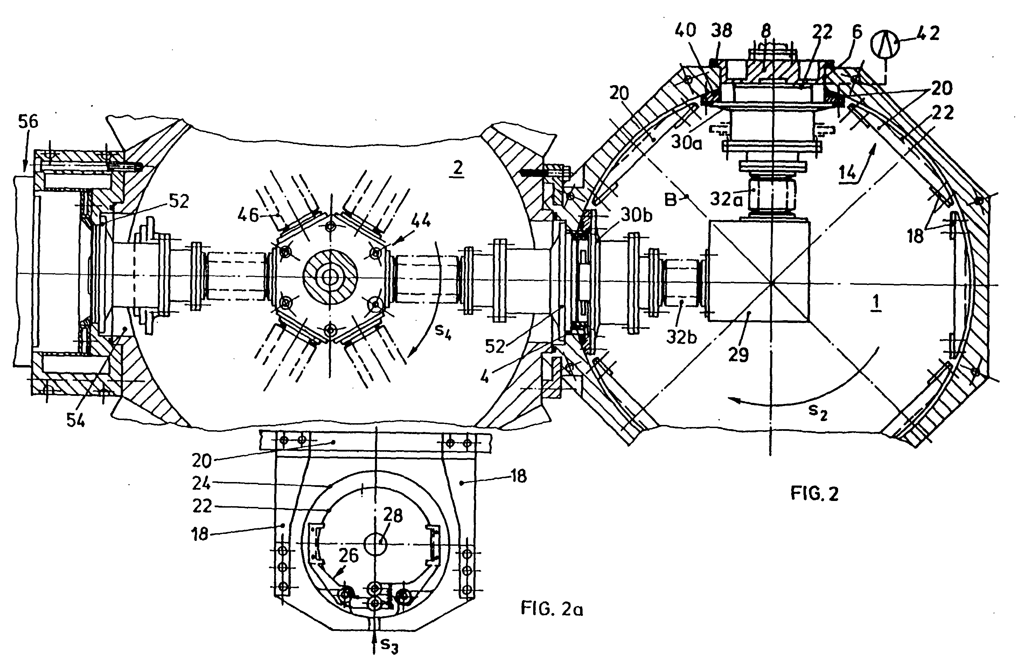

Anhand der Fig. 1, 2, 2a soll vorerst eine heute bevorzugte Anlagenkonstellation beschrieben werden, welche das erfindungsgemässe Vorgehen umfasst. Fig. 1 ist weitergehend schematisiert als Fig. 2, aus Uebersichtsgründen. Es sind in den Fig. 1 bis 2a die gleichen Bezugszeichen verwendet.

Die Anlage umfasst eine erste Kammer 1 und eine zweite Kammer 2, welche über eine Verbindungsöffnung 4 miteinander kommunizieren. Die erste Kammer 1, als Pufferkammer ausgebildet, weist (Fig. 2) eine Zuspeise- bzw. Entnahmeöffnung 6 - eine Schleusenöffnung - auf, die mit einem getrieben betätigten Zuführ- und Verschlussteller 8 dichtend verschliessbar ist. Zentral am Gehäuse der ersten Kammer 1 gelagert, ist ein Drehantrieb 10 vorgesehen, welcher über eine Antriebsachse 12 ein Karussell 14 antreibt. Letzteres umfasst eine Uebertragerplatte 16, woran, über Blattfedern 18 (siehe auch Fig. 2a) Aufnahmen 20 für kreisscheibenförmige Werkstücke 22 angeordnet sind. Aufgrund der Blattfedernaufhängung sind die Aufnahmen 20, wie in Fig. 1 bei s₁ dargestellt, radial federnd ausbiegbar.

Die am Karussell 14 vorgesehenen acht Aufnahmen 20 sind im wesentlichen als Rahmen ausgebildet, wie insbesondere in Fig. 2a ersichtlich. Sie weisen, senkrecht zur Ausdehnungsfläche der Werkstücke 22 betrachtet, eine Durchgriffsöffnung 24 auf sowie, aus Uebersichtsgründen nur in Fig. 2a eingetragen, einen zangenähnlich wirkenden Festhaltemechanismus 26 für die Werkstücke 22 über der Durchgriffsöffnung 24. Aufgrund der randseitigen Anordnung (Fig. 2a) der Blattfedern 18 bleibt die Durchgriffsöffnung 24 frei.

Die Werkstücke, hier Speicherplatten, weisen eine Zentrumsöffnung 28 auf. Durch schrittweises Drehen des Karussells 14 werden Aufnahmen 20 sequentiell über die Oeffnungen 4 und 6 der Kammer 1 gedreht.

Wie insbesondere auch in Fig. 2 ersichtlich, ist bezüglich der Achse A₁₄ des Karussells 14 in Kammer 1, dem Uebertrager 16 gegenüberliegend, ein Lagersockel 29 am Gehäuse der Kammer 1 starr montiert, woran, ausgerichtet auf die hier beispielsweise vorgesehenen zwei Oeffnungen 4 und 6, entsprechend, zwei unabhängig voneinander radial aus- und einschiebbare Teller 30a und 30b angeordnet sind. Die Antriebsorgane für die Teller 30a und 30b sind vakuumtechnisch über Bälge 32a, b abgedichtet bzw. abgekapselt. Pneumatische Steuerleitungen 34a bzw. b sind, wie in Fig. 1 schematisch dargestellt, in den Block 29 geführt. Wie mit 36 weiter schematisch in Fig. 1 dargestellt, weist die Kammer 1 einen Pumpanschluss 36 zu deren Konditionierung auf, gegebenenfalls auch Gasanschlüsse.

Durch das an der Kammer 1 realisierte Prinzip des Karussells mit einer Vielzahl von Aufnahmen 20 für Werkstücke und den radial wirkenden Tellern 30, wird, wie ersichtlich, erreicht, dass eine höhere Anzahl Werkstücke in dieser Kammer enthalten ist, als momentan durch die vorgesehenen Oeffnungen gehandhabt wird, was den grossen Vorteil mit sich bringt, dass die momentan bezüglich der erwähnten Oeffnungen nicht gehandhabten Werkstücke in dieser Kammer konditioniert, insbesondere ausgegast werden können. Dies kann durch Beheizen unterstützt werden oder andere bekannte Vorbehandlungen.

Im weiteren ist ein Vorteil darin zu erblicken, dass die Handhabung der Werkstücke bezüglich der erwähnten Oeffnungen in derselben Ebene erfolgt, in welcher mittels des Karussells die Werkstücke in Kammer 1 gedreht werden. Mithin eröffnet sich damit die Möglichkeit, eine Gesamtanlage mit der Kammer 1 und an ihren Oeffnungen angeordneten weiteren Kammern, seien dies weitere Transport- bzw. Verteilkammern oder Bearbeitungskammern oder Schleusenkammern, modular, kompakt auch radial, damit erwünschtenfalls flach aufzubauen.

Selbstverständlich können an der Kammer 1, jetzt für sich betrachtet, mehr als zwei Oeffnungen vorgesehen und durch entsprechend angeordnete Teller 30 radial bedient werden. Dabei bleibt die Aufbaueinfachheit erhalten, indem das Karussell sehr einfach antreibbar ist und die radialen Handhabungsbewegungen von einem stationären Zentrum aus angesteuert werden können, womit auch diese Ansteuerung wesentlich einfacher ist als wenn Drehbewegung und Axialbewegung gekoppelt werden. Grundsätzlich ist es aber, unter Beibehalt dieser einfachen Bauweise, durchaus möglich, den Sokkel 29 mit den Tellern 30 um Achse A₁₄ getrieben, aber unabhängig vom Karussell 14 zu drehen. Damit können mit weniger Tellern 30 mehr Oeffnungen bedient werden. Dies insbesondere dann, wenn die Oeffnungen nicht dicht verschlossen werden müssen, wie z.B., wenn die Dichtung mittels Diffusionsspaltdichtungen für eine betrachtete Anwendung ausreicht.

Bei der hier dargestellten Ausführung wirkt der Oeffnungsbereich an der Oeffnung 6 als eigentliche Einund Auslassschleuse für Werkstücke, während die Kammer 1 an sich der Konditionierung aus der Atmosphäre eingebrachter Werkstücke dient, bevor sie durch Oeffnung 4 in noch zu beschreibender Art und Weise hin gegen eine Bearbeitungsstation gefördert werden.

Es sei nun an der spezifisch dargestellten Konfiguration der Kammer 1 die Funktion der Werkstückzu- bzw. Wegführung durch die als eigentliche Schleuse ausgebildete Oeffnung 6 betrachtet.

Durch Drehung des Karussells 14 in der mit s₂ in Fig. 2 eingetragenen Richtung wird bei rückgeholtem Teller 30a und selbstverständlich, über Dichtungen 38, dichtend verschlossenem Zuführ/Verschliessteller 8, eine Aufnahme 20, z.B. mit fertig bearbeitetem Werkstück, in den Oeffnungsbereich gedreht. Darnach wird mit dem Teller 30a, gegen die Wirkung der Federn 18, die betrachtete Aufnahme 20 mit Dichtungen 40 dichtend an die Wandung der Kammer 1 gelegt, wobei nicht dargestellte Dichtungen zwischen Aufnahme 20 und Teller 30a die vakuumdichte Abschottung der Oeffnung 6 zur Kammer 1 sicherstellen.

Beispielsweise magnetisch, pneumatisch oder mechanisch wird das Werkstück 22, nach Lösen des Festhaltemechanismus 26 durch Wirkung eines Betätigungsstössels, wie er in Fig. 2a bei s₃ dargestellt ist, vom Zuführ/Verschliessteller 8 aus der Aufnahme 20 übernommen. Unter Beibehaltung des dichten Verschlusses von Teller 30a über Aufnahme 20 an der Wandung der Kammer 1 kann nun der Zuführ/Verschliessteller 8 abgehoben werden, das bearbeitete Werkstück wird von ihm entfernt und ein neu zu bearbeitendes eingelegt. Der Teller 8 wird mit dem neu zu bearbeitenden Werkstück wiederum dichtend verschlossen, es übernimmt der Festhaltemechanismus 26 an der nun freien Aufnahme 20 das neu zu bearbeitende Werkstück, worauf der Teller 30a in die in Fig. 2 gestrichelt dargestellte Rückholposition gefahren wird. Damit ist das Karussell frei, einen Takt in Richtung s₂ weiter zu drehen.

Wie gestrichelt bei 42 (Fig. 2) dargestellt, kann die Oeffnung 6 über einen Pumpanschluss mit einer Pumpe 42 verbunden sein, wenn höchste Reinheitsanforderungen an die Atmosphäre in der Kammer 1 gestellt werden. Angesichts des extrem kleinen Volumens des als Schleuse wirkenden Oeffnungsbereiches 6 vermag aber das Verdünnungsverhältnis, gegeben durch das Volumen im Oeffnungsbereich 6 zu Volumen der Kammer 1 auszureichen, um meistens eine genügende Reinheit der Atmosphäre in der Kammer 1 zu gewährleisten.

Wie bereits erwähnt wurde, kann der Teller 8 als Transportteller ausgebildet werden und Teil eines Transportmechanismus in einer weiteren an Oeffnung 6 angeflanschten Kammer sein oder es kann ein anders gearteter Transportmechanismus Werkstücke durch Oeffnung 6 dem Karussell 14 zuspeisen bzw. daraus entnehmen. Im weiteren ist es ohne weiteres möglich, beispielsweise in der Radialposition B, eine Entnahmeschleuse vorzusehen, beispielsweise gleich aufgebaut, wie die im Zusammenhang mit der Oeffnung 6 beschriebene und an zwei getrennten Bereichen die Werkstücke der Kammer 1 zuzuführen und ihr wieder zu entnehmen.

Wie bereits erwähnt wurde, können mehr als zwei Teller 30 vorgesehen sein, um eine entsprechende Anzahl in der Kammer 1 vorgesehener Oeffnungen zu bedienen, im Extremfall so viele, wie Aufnahmen 20 vorgesehen sind.

Wie aus Fig. 2 ersichtlich, ist der Transportweg für die Werkstücke von ihrer Eingabe in die Kammer 1 zu ihrer Ausgabe aus der Kammer 1 hin gegen eine Bearbeitungsstation wesentlich länger als der Transportweg von einer Bearbeitungsstation zurück in die Kammer 1 und von dort zur Ausgabe des Werkstückes aus der Kammer 1. Grundsätzlich wird dann, wenn Kammer 1, wie auch immer ausgebildet, als Konditionierungskammer für Werkstücke vor ihrer Bearbeitung ausgenützt wird, der Transportweg für Werkstücke von einer Aufnahmeöffnung zu einer Ausgabeöffnung für zu bearbeitende Werkstücke länger gewählt als der Transportweg für bearbeitete Werkstücke von einer diesbezüglichen Aufnahmeöffnung zu einer diesbezüglichen Ausgabeöffnung, seien nun Eingabe/Ausgabeöffnungen auch wie in Fig. 2 dargestellt, kombiniert, in Form beispielsweise von Ein/Auslassschleusen. Dadurch wird die Verweilzeit der Werkstücke in Kammer 1 als Vorkammer verlängert, während welcher die Werkstücke Wasserdampf und Gas abgeben können. Die Werkstücke werden somit für nachmalige Bearbeitungsschritte vorbereitet (konditioniert). Dies ist besonders bei Materialien wichtig, die eine grosse Gas- bzw. Wasserabsorption aufweisen, wie beispielsweise üblicherweise für Speicherplatten eingesetzte Kunststoffe. Eine zu starke Ausgasung der Werkstücke an den Prozessstationen ist deshalb nicht tolerierbar, weil dadurch die Beschichtung der Werkstücke unbrauchbar werden kann.

Es sei nun weiter die Kammer 2 und ihre Wechselwirkung mit Kammer 1 betrachtet.

In der Kammer 2 ist ein Transportstern 44 mit beispielsweise sechs Transportarmen 46 vorgesehen, welcher durch einen Antrieb 48, über Achse 50 drehend angetrieben wird. Endständig sind an den Armen 46 mit vakuumdicht gekapselten Antriebsorganen radial vorund rücktreibbare Teller 52 angeordnet. Die Teller 52 sind über die Oeffnung 4 zu Kammer 1 einerseits, sowie zu einer oder mehreren zusätzlichen Oeffnung(en) 54 schwenkbar, an welchen, wie am dargestellten Beispiel, eine oder mehrere Bearbeitungsstation(en) angeordnet sein können und/oder weitere Transportkammern bzw. Schleusenkammern. Am dargestellten Beispiel ist eine Bearbeitungskammer 56 vorgesehen.

Es sei nun die Uebergabe von Kammer 1 nach Kammer 2 von Werkstücken betrachtet. Die Werkstücke müssen für ihre Oberflächenbearbeitung in einer Bearbeitungsposition stromab der Oeffnung 4, d.h. in Bewegungsrichtung der Werkstücke hinter der Oeffnung 4, an erwünschten Oberflächenbereichen abgedeckt werden. Im hier betrachteten Fall von Speicherplatten muss für die Bearbeitung sowohl ihr Zentrumsbereich um die Oeffnung 28 sowie ihr Peripheriebereich an mindestens einer der Bearbeitungsstationen abgedeckt werden.

In noch zu beschreibender Art und Weise wird die Zentralmaskierung durch ein lose zugeführtes Maskierungselement je zu bearbeitendes Werkstück sichergestellt, welches, wie beschrieben werden wird, vor Bearbeitung den Werkstücken appliziert und nach Bearbeitung davon wieder entfernt wird. Die Maskierungsorgane 58 welche, nach deren Bearbeitung an den auf den Tellern 52 rückgeführten Werkstücken appliziert sind, werden im Bereich der Oeffnung 4 von diesen bereits bearbeiteten Werkstücken weggenommen und einem neu auf einem der Teller 52 in der Kammer 2 aufgebrachten Werkstück appliziert, das darnach, durch Drehen des Transportsternes 44, in Bearbeitungsposition gebracht wird. Hierzu ist am drehfesten Teller 30b von Kammer 1 ein Elektromagnet zentral angeordnet.

In der beispielsweise in Fig. 2 dargestellten Drehrichtung s₄ werde ein scheibenförmiges Werkstück 22 der angesprochenen Art in die in Fig. 1 dargestellte Position gegenüber der Oeffnung 4 transportiert. Der entsprechende Teller 52 wird mit Dichtungen 62 dicht an die Umrandung der Oeffnung 4 angelegt. Das auf ihm reitende Werkstück 22, gehaltert durch ein Magnet 64, vorzugsweise ein Permanentmagnet, wird damit in die Oeffnung 4 eingeschoben. Während der Drehbewegung des Tellers 52 um Achse 50 bzw. A 44 bleibt eine Aufnahme 20 ohne Werkstück, also eine leere Aufnahme 20, über Oeffnung 4 positioniert. Der Teller 30b presst dabei diese leere Aufnahme 20 über Dichtungen 66 und Dichtungen 68 dicht auf die Kammer-1-seitige Umrandung von Oeffnung 4, so dass während der Drehbewegung des Transportsternes 44 die beiden Kammern 1 und 2 dichtend, gegebenenfalls vakuumdicht, getrennt sind.

Wenn nun seinerseits der Teller 52 in Position gebracht, mit den Dichtungen 62 diese Trennung seitens Kammer 2 gewährleistet, wird der Elektromagnet 60 am Teller 30b aktiviert, das Maskierungsorgan 58, aus magnetischem Material, ergriffen und durch Rückzug des Tellers 30b ausser Eingriff mit dem Werkstück 22 und dem Teller 52 gebracht. Durch Betätigung eines Stössels, wie schematisch in Fig. 1 bei 70 dargestellt, ergreift der Festhaltemechanismus 26 gemäss Fig. 2a in der Aufnahme 20 das bearbeitete Werkstück 22. Nachdem der Teller 30b mit dem Maskierungsorgan 58 magnetisch daran gehaltert, rückgezogen ist, wird das Karussell 14 um einen Takt in Richtung s₂ weiter gedreht, wodurch eine nun mit einem nicht bearbeiteten Werkstück geladende Aufnahme 20 über die Oeffnung 4 gedreht wird. Das vormals behandelte, vom Maskierungsorgan befreite Werkstück liegt nun mit seiner zugeordneten Aufnahme 20 gemäss Fig. 2 in der Winkelposition B. Durch Vorschieben des Tellers 30b, weiterhin mit dem vormals aufgenommenen Maskierungsorgan 58, wird letzteres dem neu zugeführten Werkstück 22 appliziert. Mittels der Dichtungen 66 und 68 an der nun neu eingeschobenen Aufnahme 20 wird wiederum die Kammertrennung sichergestellt.

Der Elektromagnet 58 wird nun desaktiviert, womit der Magnet 64 das Maskierungsorgan 58 mit dem Werkstück an den Teller 52 zieht und hält. Durch den dicht, vorzugsweise vakuumdicht (Balg), gebauten Stössel 70 wird hierzu der Festhaltemechanismus 26 gelöst.

Damit liegt nun das Werkstück maskiert auf dem Teller 52. Die Aufnahme 20 ist leer und bereit zur Aufnahme eines bearbeiteten Werkstückes im nächsten Zyklus. Der frisch geladende Teller 52 wird rückgeholt, die Kammertrennung ist durch Teller 30b und leere Aufnahme 20 sichergestellt. Durch Drehen des Transportsternes 44 wird einerseits das eben geladene Werkstück gegen seine Bearbeitungsposition weiter gedreht, anderseits ein bereits bearbeitetes in Position gegenüber der leeren Aufnahme 20 gedreht. Die Dichtung 68 ist z.B. an der Aufnahme 20 angeordnet und hat bei der hier dargestellten Anlage an der Oeffnung 6 schleusendichtende Aufgabe. Wie die Dichtung 68 können auch die Dichtungen 66 und/oder 62 als Diffusionsspaltdichtungen ausgebildet sein, wenn bei weniger heiklen Bearbeitungsprozessen eine vakuumdichte Trennung zwischen den Kammern 1 und 2 nicht erforderlich ist oder beispielsweise der Kammer 2 nachgeschaltete Bearbeitungs- und/oder Transportkammern für sich Abtrennorgane und Konditionierungsmittel aufweisen.

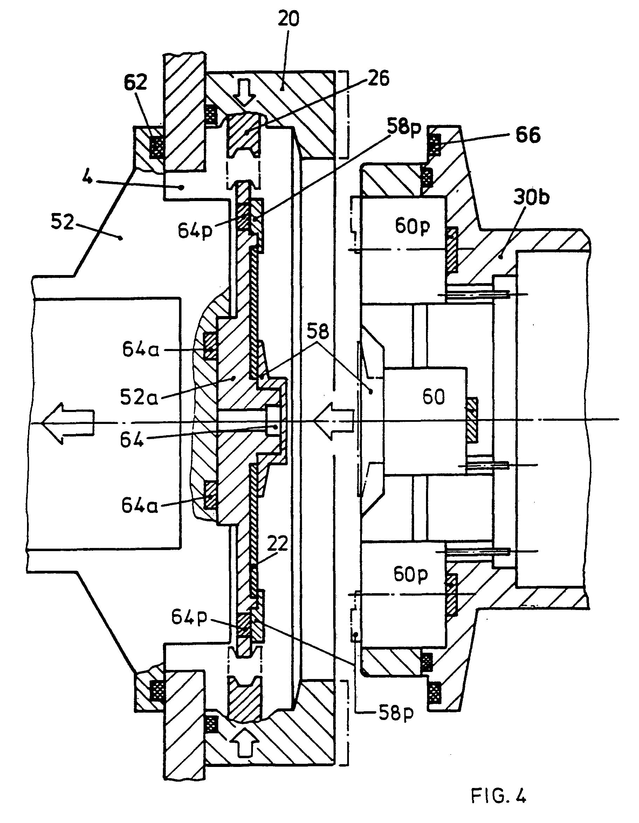

Wenn jeweils ein Arm 46 des Transportsternes 44 gegenüber einer Bearbeitungsstation bzw. der dazu führenden Oeffnung, wie 54, positioniert ist, wird sein Teller 52 vorgetrieben und legt sich beispielsweise und falls erforderlich, mit den Dichtungen 62 an die Umrandung der Oeffnung 54. Es erfolgt die Oberflächenbearbeitung des maskierten Werkstückes 23, sei dies z.B. durch einen Aetzprozess oder einen Beschichtungsprozess. Am dargestellten Beispiel für Speicherplatten wird die periphere Maskierung durch einen Maskierungsring 72 ortsfest an der Bearbeitungsstation 56 montiert, realisiert, welcher federnd ausgebildet sein kann. Es ist jedoch ohne weiteres möglich, falls erforderlich, auch periphere oder andere Maskierungsorgane prinzipiell gleich wie das Zentral-Maskierungsorgan 58 zu handhaben, was noch anhand von Fig. 4 erläutert werden wird.

Wie bereits erwähnt, können auch an der Kammer 2 mehrere Bearbeitungsstationen vorgesehen sein und/oder gewisse der vorgesehenen Oeffnungen in weitere Transport- bzw. Verteilkammern ausmünden oder auch weitere Schleusenkammern. Wie schematisch bei 74 dargestellt, wird bei der dargestellten Anlage auch Kammer 2 für sich evakuiert bzw. konditioniert.

Die Steuerleitungen für den Antrieb der Teller 52 werden (nicht dargestellt) durch die Achse 50 des Sterns 44 geführt.

Wie in den Fig. 1 bis 2a nicht dargestellt, werden Maskierungsorgane 58 dann, wenn sie durch die Bearbeitung verbraucht sind, z.B. wenn nach mehreren Durchläufen deren Beschichtung zu dick geworden ist, nicht mehr in die Kammer 2 rückgeführt, sondern werden, z.B. mit dem Teller 30b, nicht mehr abgehoben und am bearbeiteten Werkstück verbleibend ausgeschleust. Da dies vorausgeplant ist, wird ein nicht bearbeitetes, mit der Aufnahme 20, wie oben beschrieben wurde, neu zugeführtes Werkstück, bereits mit einem Maskierungsorgan 58 in die Kammer 1 eingegeben, womit das ausgediente Maskierungsorgan 58 ersetzt wird.

Die vorliegende Erfindung wurde anhand eines bevorzugten speziellen Ausführungsbeispiels gemäss den Fig. 1 bis 2a dargestellt.

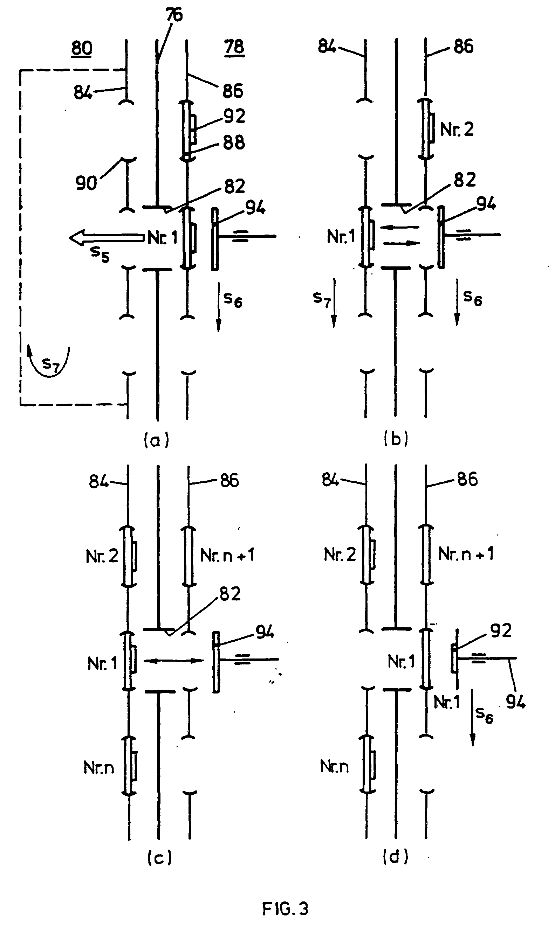

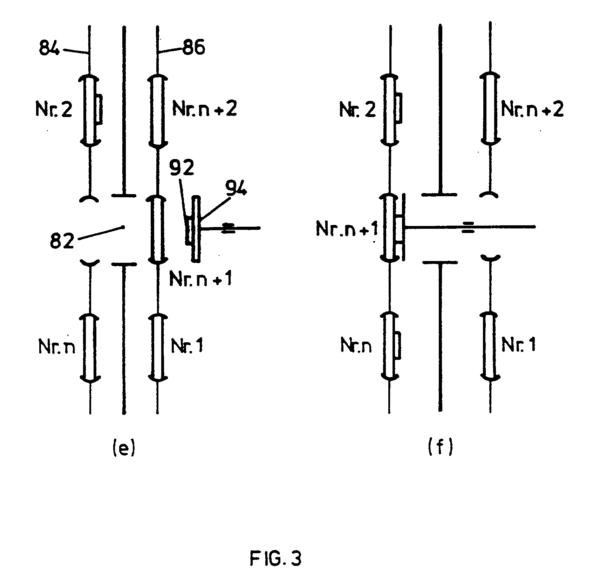

In Fig. 3 ist in prinzipieller Art dargestellt, wie grundsätzlich der Maskenwechsel zwischen zwei Transportorganen erfolgt, wenn dem diesbezüglichen Konzept gemäss den Figuren 1, 2, 2a gefolgt wird.

Gemäss Fig. 3a werden zwei Kammern 80 und 78 durch die Trennwand 76 mit Oeffnung 82 getrennt. In jeder Kammer ist eine Transportvorrichtung angeordnet, hier schematisch als Bandförderer 84 bzw. 86 dargestellt. An jedem der Förderer sind steuerbare Festhalteorgane für die Werkstücke 88 vorgesehen, wie schematisch bei 90 dargestellt. Die Transportrichtung der Werkstücke 88 gegen die Bearbeitungsposition erfolgt von Kammer 78 in Kammer 80, wie durch s₅ dargestellt. Es werde nun die Anlage in Betrieb gesetzt.

Gemäss Fig. 3a ist dabei die Transportvorrichtung 84 leer, während mit der Transportvorrichtung 86 Werkstücke 88 gemeinsam mit den als separate Teile ausgebildeten Maskierungsorganen 92 in der mit s₆ angedeuteten Richtung zugeliefert werden. Das erste angelieferte Werkstück No. 1 wird über Oeffnung 82 gefördert und, wie in Fig. 3b dargestellt, mit dem Quertransportorgan 94, z.B. in Form eines Stössels, vom Förderer 86 durch Oeffnung 82 in Förderer 84 geschoben. Der Förderer 84 wird nun gemäss Fig. 3b in der beispielsweise eingetragenen Richtung s₇ weitergetaktet.

Dieser Vorgang läuft so lange, bis der zyklisch umlaufende Förderer 84 vollständig mit Werkstücken geladen ist, wovon ein Teil bereits bearbeitet ist. Dabei war bis anhin Förderer 86 in Förderrichtung stromab der Oeffnung 82 immer geleert.

Am Förderer 84 seien n Werkstücke applizierbar. Nun erscheint nach seiner Bearbeitung, in Förderrichtung, stromab der Oeffnung 82, das Werkstück No. 1, wieder vor der Oeffnung 82 gemäss Fig. 3c. Das Werkstück No. (n+1) am Förderer 86 wird nun, ohne Maskierung 92, zugeliefert. Wie durch den Uebergang auf Fig. 3d ersichtlich, wird mit dem Quertransportorgan 94 einerseits das bearbeitete Werkstück No. 1 vom Förderer 84 in den Förderer 86 übergeführt und, andererseits, das Maskierungsorgan 92 vom Werkstück No. 1 abgehoben.

Daraufhin wird der Förderer 86 einen Schritt in Richtung s₆ weiter bewegt. Damit entsteht die in Fig. 3e dargestellte Situation: Das bearbeitete Werkstück No. 1 wird zu einer Ausgabe aus Kammer 78 gefördert, während nun das Werkstück No. (n+1) über der Oeffnung 82 liegt. Mit dem Quertransportorgan 94 wird das Maskierungsorgan 92, welches bereits einen Umlauf von Oeffnung 82 zu Oeffnung 82 durch Kammer 76 durchlaufen hat, auf das unbearbeitete Werkstück No. (n+1) appliziert und dieses Werkstück, wie aus Fig. 3f hervorgeht, vom Förderer 86 durch Oeffnung 82 in Förderer 84 übergeführt.

Damit ist am Förderer 86 die Werkstückaufnahme frei, womit sich nun die Zyklen gemäss Fig. 3(c) bis (f) wiederholen können.

In Fig. 4 ist anhand eines schematisch dargestellten Ausschnittes mit der Oeffnung 4 an der Anlage gemäss Fig. 1 eine weitere Ausbildung der Anlage dargestellt, bei der auch Peripher-Maskierungsorgane 58p, so wie das vorbeschriebene Maskierungsorgan 58, gewechselt werden. Der Teller 52 mit Dichtungen 62 trägt in der dargestellten Ausführungsform, was nicht zwingend mit dem erwähnten Maskierungskonzept zu koppeln ist, eine Fahrzeugplatte 52a, welche magnetisch, vorzugsweise mittels Permanentmagneten 64a, am Teller 52, gehaltert ist.

Die Fahrzeugplatte 52a ihrerseits trägt teller-52-seitig Periphermagnete 64ₚ sowie das zentrale Magnet 64. Eine Aufnahme 20 mit ihren Dichtungen wird, wie beschrieben wurde, durch Teller 30_{b} mit Dichtungen 66 gegen die Berandung der Oeffnung 4 getrieben. Am Teller 30_{b} sind Elektromagnete 60ₚ für das periphere Maskierungsorgan 58p bzw. 60 für das zentrale 58 vorgesehen. Mit den Magneten 60ₚ wird die Weitergabe des peripheren Maskierungsorgans 58p bewerkstelligt, in Analogie zu der vorbeschriebenen bezüglich des Maskierungsorgans 58.

Bei der Fahrzeugplatte 52a kann es sich um eine Werkstückadapterplatte handeln, welche jeweils entsprechend zu bearbeitenden Werkstücken 22 ausgewechselt wird. Sie durchläuft gemeinsam mit dem jeweiligen Werkstück 22 mindestens einen Teil der Werkstücktransportbahn. Wie schematisch dargestellt, greift der Festhaltemechanismus 26 bei Vorsehen der Fahrzeugplatte 52a an letzterer an.

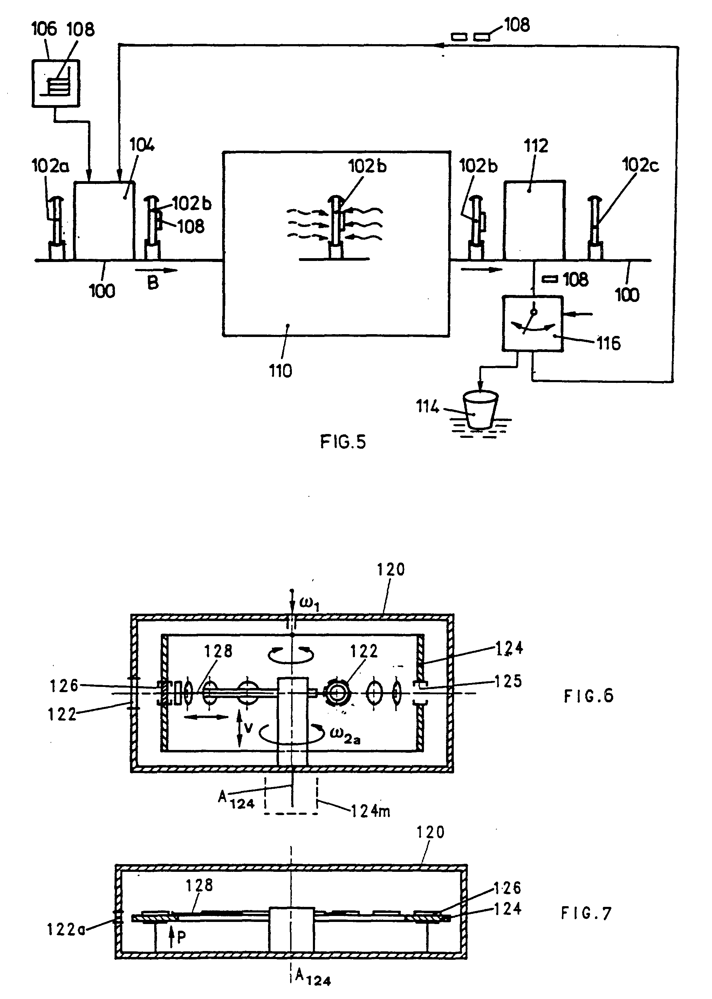

In Fig. 5 ist zum Aufzeigen der Allgemeinheit des beschriebenen Maskierungsverfahrens bzw. der Anlage hierfür dessen bzw. deren Grundprinzip dargestellt. Auf einem Förderer 100 werden, wie schematisch dargestellt, Werkstücke 102a, ohne Maskierung, einer entlang des Förderers 100 und damit der Bewegungsbahn B der Werkstücke 102 wirkenden Applikationsstation 104 zugeführt, die von einem Magazin 106 mit losen Maskierungselementen 108 gespiesen wird. Ausgangsseitig der Applikationsstation 104, d.h. der Station, an der Maskierungselemente 108 den Werkstücken 102a aufgebracht werden, werden die nun mit dem Maskierungselement 108 versehenen Werkstücke 102b einer oder mehreren Bearbeitungsstationen zugeführt, generell dargestellt in Fig. 5 mit der Vakuumoberflächenbearbeitungsanordnung 110, worin die erwähnten Werkstücke 102b ein- oder zweiseitig oder rundum oberflächenbearbeitet werden. Ausgangsseitig der Anordnung 110 werden die nun bearbeiteten weiterhin maskierten Werkstücke 102b einer entlang der Bewegungsbahn B der Werkstücke wirkenden Entnahmestation 112 zugeführt und verlassen die Entnahmestation 112 als nun bearbeitete Werkstücke 102c, ohne Maskierungselement 108. Die an der Station 112 entfernten Maskierungselemente 108 werden entweder an die Applikationsstation 104 rückgespiesen, oder, wenn sie nach mehreren Rückführungszyklen durch Wirkung der Bearbeitungsanordnung 110 verbraucht sind, wie bei 114 dargestellt, aus dem Umlauf gezogen. Dies über eine schematisch dargestellte gesteuerte Selektionseinheit 116.

Anhand der Fig. 6 und 7 soll das allgemein gültige Prinzip der Transporttechnik, wie sie an der bevorzugten Anlage gemäss den Fig. 1 bis 2a in der Kammer 1 realisiert ist, dargestellt werden.

Gemäss Fig. 6 ist in der Transportkammer 120, welche für sich und/oder durch mindestens eine der mindestens zwei vorgesehenen Kammeröffnungen 122 vakuumtechnisch konditionierbar ist, ein Karussell 124 vorgesehen, welches, wie bei ω₁ dargestellt, gesteuert drehgetrieben wird. Am Karussell sind, wie auch immer geartete, gegebenenfalls gesteuerte Festhalteorgane 125 für Werkstücke 126 vorgesehen.

Gemäss der Ausbildung nach Fig. 6 werden am Karussell 120 z.B. scheibenförmige Werkstücke 126 so gehaltert und transportiert, dass ihre Scheibenflächen bei Drehung um die Drehachse des Karussells 124 eine zylindrische Fläche aufspannen. Bezüglich der Drehachse A₁₂₄ des Karussells 124 in einer bevorzugten Variante drehfest radial gesteuert ausfahr- bzw. rückholbar, sind Schuborgane 128 vorgesehen. Sind sie drehfest, so ist ihre Anzahl gleich der Anzahl damit zu bedienender Oeffnungen 122 in der Kammer 120, welche Anzahl aber nicht zwingend gleich der Anzahl an der Kammer 120 überhaupt vorgesehener, von den Werkstükken durchlaufener Oeffnungen zu sein braucht.

Das Karussell 124 wird bevorzugterweise in Schritten drehgetrieben, so dass jeweils eine Aufnahme 125 auf eine zu bedienende Kammeröffnung 122 ausgerichtet wird, worauf mit dem besagter Kammeröffnung 122 fest zugeordneten Schuborgan 128 das positionierte Werkstück 126 in Richtung aus der Kammer 120 ausgegeben wird, oder, umgekehrt, durch besagte Oeffnung 122 ein Werkstück von ausserhalb der Kammer 120 rück- oder eingeholt wird.

Wie ersichtlich, können an einer solchen Transportkammer 120 in gezielt konditionierter Atmosphäre mehr Werkstücke 126 zwischengelagert werden als Schuborgane 128 vorgesehen sind. Es wird die Drehbewegung um die Achse 124 und die Radialbewegung, wie mit den Schuborganen 128 durchgeführt, getrennt, womit die Realisation der entsprechenden Antriebe und Steuerleitungen wesentlich vereinfacht wird.

Es ergibt sich eine optimale flache Kammer 120 aufgrund der Tatsache, dass sowohl die notwendige Drehbewegung des Karussells, wie auch die Radialbewegung der Schuborgane in einer Ebene erfolgen.

Letzteres ist allerdings nicht zwingend, sondern bevorzugt. Es ist durchaus möglich, die Schuborgane 128 zur Achse A₁₂₄ schiefwinklig anzuordnen, wie strichpunktiert in Fig. 6 angedeutet und, entsprechend, die Halterungen am Karussell sowie die Oeffnungen in der Kammer 120 vorzusehen. Im weiteren ist es auch möglich, an dem in Fig. 6 dargestellten Karussell, wie gestrichelt dargestellt, in Axialrichtung A₁₂₄ betrachtet, zwei oder mehr Lagen von Werkstücken vorzusehen und mittels in dieser Achsrichtung gestaffelter Schuborgane 128, Kammeröffnungen 122 zu bedienen oder gar, wie mit v dargestellt, die vorgesehenen Schuborgane 128 wohl weiterhin drehfest vorzusehen, aber in Axialrichtung gesteuert verschieblich. Wie in Fig. 6 mit ω₂ₐ dargestellt, ist es ohne weiteres möglich, auch die Schuborgane 128 um die Achse A₁₂₄ zu drehen, mit einem separaten Drehantrieb, wie gestrichelt bei 128ₘ dargestellt. Wie dem Fachmann ersichtlich, ergibt sich eine Vielzahl von Möglichkeiten, das an der Kammer 120 bzw. 1 gemäss Fig. 1 - 2a realisierte Transportprinzip den jeweiligen Bedürfnissen entsprechend zu modifizieren.

Aus dieser Vielzahl sich nun eröffnender Möglichkeiten ist in Fig. 7 eine weitere dargestellt, die ermöglicht, die Transportkammer 120 in ihrer Bauhöhe wesentlich zu reduzieren. Das Karussell 124 ist hier so ausgebildet, dass die kleinste Werkstückdimension, bei deren Ausbildung als scheibenförmige Werkstücke 126 deren Dickenausdehnung, parallel zur Karussellachse 124 liegt. Analog, wie in Fig. 6, sind die Schuborgane 128 ausgebildet, und die vorgesehenen Oeffnungen 122a werden zu Schlitzen.

Es sei nun die Ausbildung der Kammer 2 in ihrer Allgemeinheit betrachtet, sowie das Konzept des Anlagenaufbaus, unter Verwendung jeweils mindestens einer Kammer nach dem Konzept von Kammer 1 bzw. von Kammer 2.

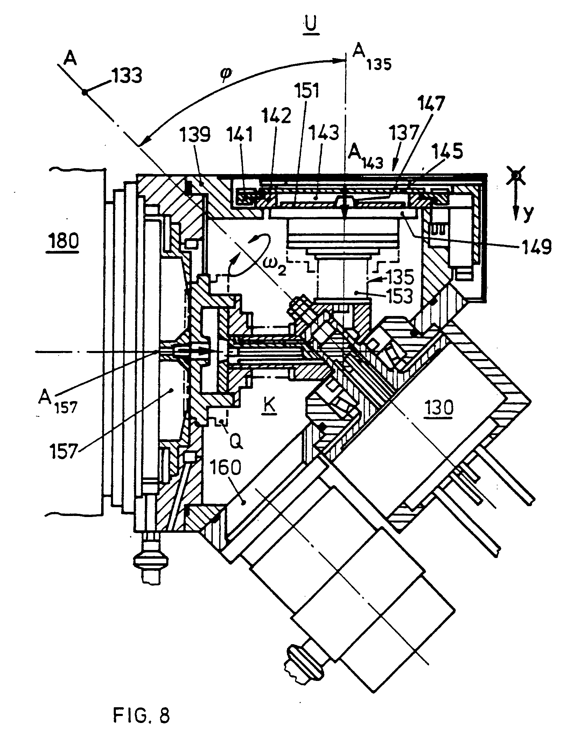

In Fig. 8 ist eine Querschnittsdarstellung einer weiteren Ausführungsvariante einer Kammer 2 gemäss den Fig. 1, 2 dargestellt. Sie umfasst einen Antriebsmotor 130, auf dessen Achse, als Raumachse A und physische Antriebsachse 133, mindestens ein Transportarm 135 mit einer Achse A₁₃₅ gewinkelt, beispielsweise um 45° zur Raumachse A gewinkelt, befestigt ist. Wird mittels des Motors die Antriebsachse 133, wie bei ω₂ dargestellt, in Drehung versetzt, so überstreicht der oder die Transportarm(e) 135 eine Kegelfläche mit hier z.B. 45° Kegelöffnungswinkel ϕ. In Fig. 7 weist die Kammer K zwei zu bedienende Oeffnungen auf. Eine erste Oeffnung 137 ist beispielsweise und wie dargestellt, direkt als Schleusenöffnung ausgebildet. Dann braucht eine, z.B. nach dem Prinzip der Kammer nach den Figuren 5, 6 aufgebaute weitere Kammer 180 gegebenenfalls keine Schleuse aufzuweisen. Sie umfasst einen Rahmen 139, daran angeflanscht einen auf- und abbeweglichen Rahmen 141. Innerhalb des getrieben auf- und abbeweglichen Rahmens 141 liegt ein Dichtrahmen 142, der das Schleusenvolumen 143 festlegt, mit einer Normalen A₁₄₃. Die Schleusenöffnung 137 umfasst weiter einen Deckel 145, welcher z.B. linear in Richtung x verschieblich ist. Er kann selbstverständlich auch um eine in Fig. 7 vertikale Achse zum Oeffnen und Schliessen schwenkbar sein. Er wird in seiner geschlossenen, dargestellten Position durch Absenken des Zwischenrahmens 141 in Richtung y, dichtend auf den Dichtrahmen 142 gelegt.

Damit wird die Schleusenöffnung 137 gegen die Umgebung U abgedichtet.

Der Transportarm 135 trägt, endständig, als Trägerpartie einen Teller 149, worauf ein zu behandelndes Werkstück, im dargestellten Beispiel eine Speicherscheibe 151, ruht. Wie gestrichelt dargestellt, kann am Transportarm 135 der Teller 149 von seinem Sitz (eingezeichnet) am Dichtrahmen 142 gegen die Raumachse A rückgeholt werden und damit die Schleuse transporteinrichtungsseitig geöffnet werden. Der Teller 149 braucht nicht dicht am Rahmen 142 anzuliegen, wenn in Kammer K nicht eine höchsten Reinheitsanforderungen genügende Atmosphäre aufrechterhalten werden muss. Das Werkstück 151 wird mit dem Transportarm durch Drehen der Welle 133 mittels des Motors 130 an die zweite dargestellte Oeffnung 157 gefördert. Der Radial-Antriebsmechanismus am Transportarm 135, dessen Ausbildung an sich die vorliegende Erfindung nicht tangiert und für welchen sich dem Fachmann manche Realisationsmöglichkeiten eröffnen, ist, was wesentlich ist, direkt an dem drehbaren Transportarm vorgesehen und mit einem Balg 153 vakuumdicht gegen die Umgebung in der Kammer K abgedichtet. Durch Drehen des Transportarmes 135 wird das Werkstück 151, nämlich die Scheibe, in den Bereich der zweiten Oeffnung 157 gefördert. Die Oeffnung 157 legt die Oeffnungsflächennormale A₁₅₇ fest. Aus der gestrichelt dargestellten Annäherungsposition Q heraus wird der Transportteller 149 mit dem Werkstück 151 in die ausgezogen dargestellte Position mittels des erwähnten beispielsweise pneumatischen Hubmechanismus am Arm 135 wieder angehoben, so dass sich der Teller 149 nun dichtend an den Rand der Oeffnung 157 anlegt.

Gegenüber der Umgebung U ist die Kammer K vorzugsweise vakuumdicht aufgebaut. Es werden je nach Einsatzzweck (nicht dargestellt), an den den Oeffnungen der Kammer K angekoppelten Stationen und/oder Transportkammern und/oder an der Kammer K selbst und/oder an der Schleusenöffnung 137, Einrichtungen vorgesehen, um gezielt jeweilige Atmosphären einzustellen, d.h. es werden daran Evakuierungsanschlüsse und/oder Gaseinlässe vorgesehen. Ein Pumpanschluss 160 für Kammer K und gegebenenfalls die Schleusenöffnung 137, sind in Fig. 8 dargestellt.

Ist die Kammer so ausgebildet, dass alle Kammeröffnungen durch je einen der vorgesehenen Arme 135 dichtend verschlossen werden, so ergibt sich damit die Möglichkeit, die jeweiligen Atmosphären in den den Oeffnungen zugeordneten Bearbeitungsstationen und/oder Transportkammern und/oder Schleusenstationen, unabhängig von derjenigen in der Kammer K vorzugeben. In gewissen Fällen kann es aber durchaus genügen, eine gemeinsame Atmosphäre für mindestens eine weitere Kammer bzw. Station und die Kammer K vorzusehen, womit dann beispielsweise nur die Kammer K zu konditionieren bzw. zu evakuieren ist, wie in Fig. 8 z.B. dargestellt, gemeinsam z.B die Schleusenöffnung 135 und die Kammer K.

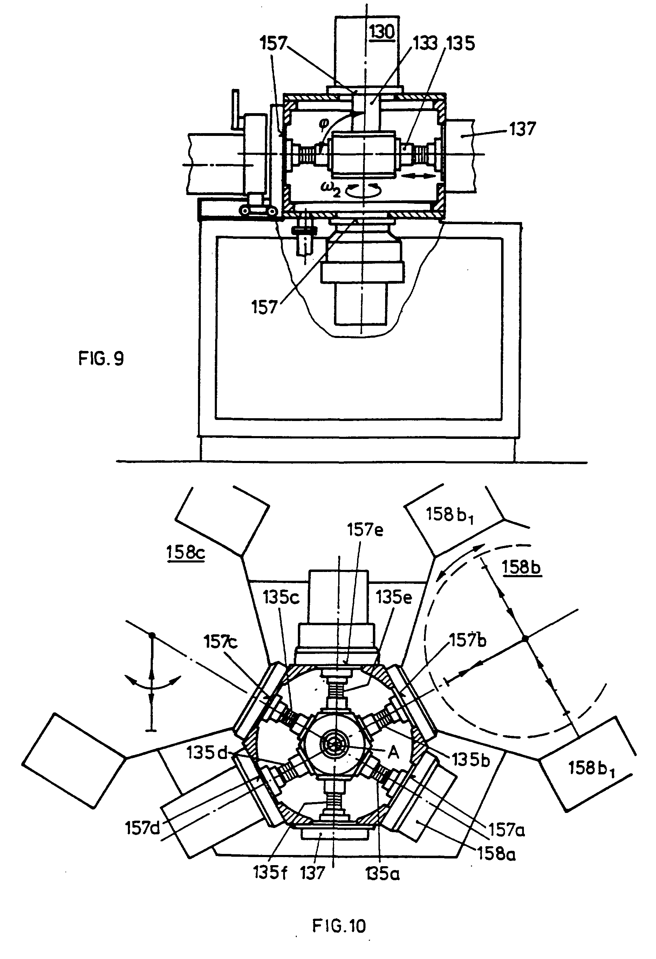

In Fig. 9 ist eine teilweise geschnittene Kammer, dem Prinzip von Kammer 2 in Fig. 1 - 2a folgend, dargestellt, bei der die Arme 135 von der Achse 133 des Motors 130 senkrecht ausragen, womit ϕ = 90° wird.

In Fig. 10 ist die Kammer, Teil einer Anlage in der Konfiguration gemäss Fig. 9, in Aufsicht dargestellt. Es bezeichnen gleiche Bezugszeichen die gleichen Bauelemente. Es sind um die Achse A z.B. sechs Transportarme 135a bis 135f angeordnet, analog wie in Fig. 9 ersichtlich und sie bedienen abwechselnd z.B. eine Schleusenstation 158a für die Ein- und Ausgabe von Scheiben 151 Scheiben 151 und eine Transportkammer 158b mit Stationen 158b₁, weitere fünf Kammern bzw. Bearbeitungsstationen durch Oeffnungen 157a bis 157e.

Die Oeffnung 157b ist z.B. einer Transportkammer 158b mit Karussell und Schuborganen, analog zur Kammer 1 bzw. den mit den Fig. 6 und 7 erläuterten, zugeordnet. Diese Kammer 158b ist mit weiteren Bearbeitungsstationen und/oder weiteren Transportstationen verbunden. Die Oeffnung 157c ihrerseits ist beispielsweise mit einer weiteren Kammer 158c des Typus gemäss Kammer 2 von Fig. 1 und wie sie weiter im Zusammenhang mit Fig. 8 erläutert wurde, verbunden, letztere wiederum mit weiteren Bearbeitungs- und/oder Transport- und/oder Schleusenkammern. Die dargestellte Konstellation der Gesamtanlage soll nur ein Beispiel dafür liefern, wie flexibel, modular, sowohl mit Kammern des Typs gemäss Kammer 1 von Fig. 1 - 2a und oder des Typs gemäss Kammer 2 von Fig. 1 - 2a Anlagen zusammengestellt werden können. Es soll auf diese Flexibilität noch weiter eingegangen werden, wobei bereits in Fig. 10 die nachmals noch zu definierenden Kammertypsymbole verwendet sind.

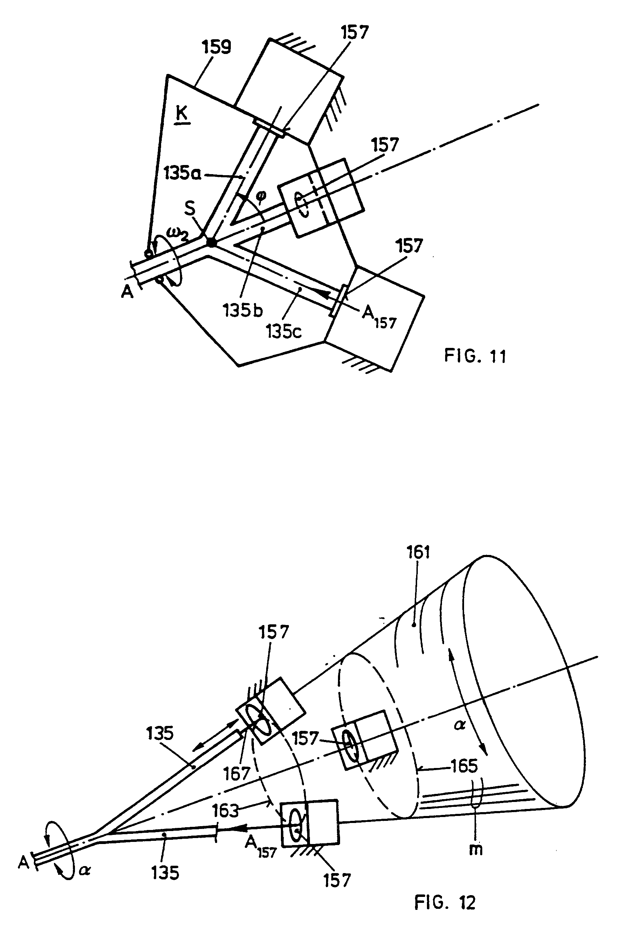

In Fig. 11 ist die anhand der Fig. 1, 2, 8 bis 10 erläuterte Kammer K weiter in ihrem Grundprinzip schematisch dargestellt. Mit den z.B. drei hier dargestellten Transportarmen 135a bis 135c, um die Raumachse A drehend, werden, beispielsweise, die eingetragenen drei Oeffnungen 157 bedient. Mit der Begrenzung 159, schematisch eingetragen, ist die Kammer K umrandet. Die Transporteinrichtung überstreicht bei ihrer Drehung ω₂ eine Kegelfläche mit Oeffnungswinkel ϕ und bedient die Oeffnungen 157, welche die Flächennormalen 157 festlegen. Letztere sind in Richtung von Mantellinien des überstrichenen Kegels gerichtet. Es liegen die Oeffnungen 157 auf einem Grosskreis der überstrichenen Kegelfläche, d.h. sie sind alle von der Spitze S des durch die Arme 135 überstrichenen Kegels, gleich weit entfernt.

In Fig. 12 ist eine weitere Möglichkeit dargestellt. Hier liegen auf dem dargestellten, von den Armen 135 überstrichenen Kegel 161 Oeffnungen auf dem einen Grosskreis 163 und weitere, wovon nur eine eingetragen ist, auf dem Grosskreis 165. Die Oeffnungsflächennormalen A₁₅₇ weisen wiederum in Richtung der Kegelmantellinien m. Um die Oeffnungen 157, welche auf unterschiedlichen Grosskreisen 163, 165 liegen, zu bedienen, sind die Arme 135, wie bei 167 schematisch dargestellt, getrieben verlängerbar bzw. verkürzbar, wie über einen pneumatischen Teleskopantrieb, z.B. abgedeckt mit hier nicht dargestelltem Balg, analog zum Balg 153 von Fig. 8. Damit wird es möglich, Oeffnungen 157 nicht nur auf einem Grosskreis, wie bei der Kammer gemäss den Fig. 8 bis 10 anzuordnen, sondern, vorzugsweise azimutal, ϕ, versetzt, auf mehreren Kegelgrosskreisen.

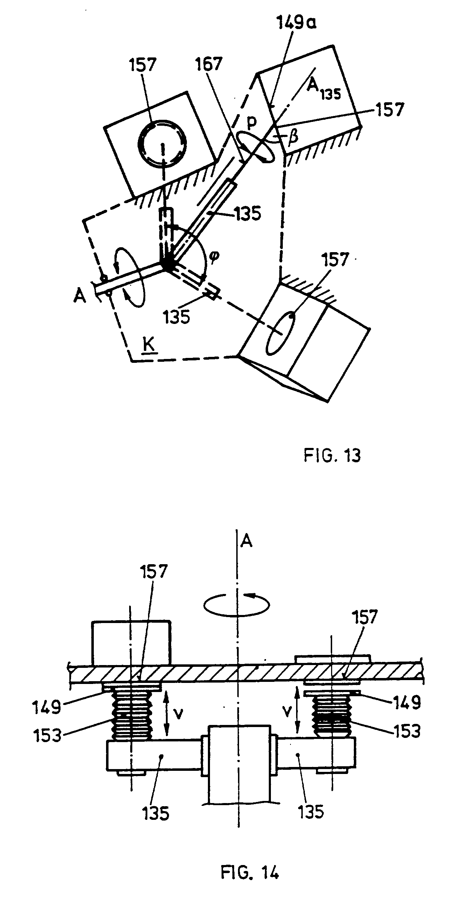

Bei einer Weiterbildung der Kammer K nach Fig. 13 sind die Arme 135, wie wiederum bei 167 dargestellt, auch ausfahrbar bzw. rückholbar und tragen eine Transportplatte 149a. Zusätzlich ist der Kegelwinkel ϕ getrieben einstellbar, so dass Kegel mit unterschiedlichen Oeffnungswinkeln ϕ überstrichen werden können. Mithin können in weiten Grenzen beliebig angeordnete Oeffnungen 157 bedient werden. Es ist zudem die Trägerplatte 149a gewinkelt in einem Winkel β ≤ 90° am jeweiligen Arm 135 gelagert und, wie bei p dargestellt, um die Armachse A₁₃₅ drehbar. Sowohl die Kegelwinkeleinstellung ϕ, wie auch das Einfahren und Ausfahren des Armes, wie auch die Drehung bei p werden gesteuert getrieben vorgenommen, womit es mit einer solchen Anordnung möglich ist, räumlich praktisch beliebig angeordnete Oeffnungen 157 zu bedienen. Gestrichelt ist wiederum die Begrenzung der Kammer K dargestellt.

Gemäss Fig. 14 sind die Arme 135 so L-förmig ausgebildet und gelagert, dass sie parallel zur Drehachse A liegen. Liegt die Raum- bzw. Drehachse A vertikal, so hat dies den wesentlichen Vorteil, dass mithin Werkstücke auf den Tellern 149 nicht gehaltert zu werden brauchen. Die Antriebe für die Bewegung v der Teller 149 liegen innerhalb der Bälge 153.

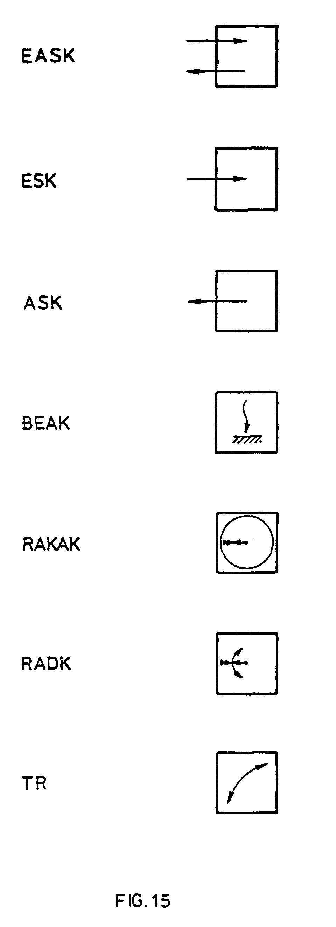

Es seien nun folgende Kammertypen definiert und, zur graphischen Vereinfachung, in Fig. 15 mit den hier definierten Abkürzungen, zeichnerische Symbole:
1. Ein- und Ausgabe-Schleusenkammer (EASK)
   Eine Schleusenkammer, womit Werkstücke in beiden Richtungen durchgeschleust werden.
2. Eingangsschleusenkammer (ESK)
   Eine Schleusenkammer, an der Werkstücke nur in Richtung gegen ihre Vakuumoberflächenbehandlung eingeschleust werden.
3. Ausgangsschleusenkammer (ASK)
   Eine Schleusenkammer, mittels welcher Werkstücke nur in Richtung von der Vakuumoberflächenbehandlung durchtransportiert werden.
4. Bearbeitungskammer (BEAK)
   Eine Kammer, worin Werkstücke oberflächenbearbeitet werden, wie abgetragen, beschichtet, gereinigt, erhitzt, gekühlt etc.
5. Radial bediente Karussellkammer (RAKAK)
   Eine Transportkammer des Typs, wie sie anhand bzw. durch Kammer 1 in den Fig. 1 und 2 sowie in den Fig. 6, 7 dargestellt und erläutert wurde.
6. Radial bediente Drehsternkammern (RADK)
   Eine Kammer des Typs der Kammer 2 von Fig. 1 und, wie sie weiter im Zusammenhang mit den Fig. 8 bis 14 dargestellt und erläutert wurde.
7. Transportkammer (TR)
   Eine Kammer, worin Werkstücke zwischen mindestens zwei Oeffnungen verschoben werden, womit die Kammern EASK, ESK, ASK, RAKAK und RADK davon umfasst sind, aber insbesondere auch Kammern mit anderen Transportmechanismen als die mit Bezug auf die Kammern RAKAK und RADK gezeigten und beschriebenen.

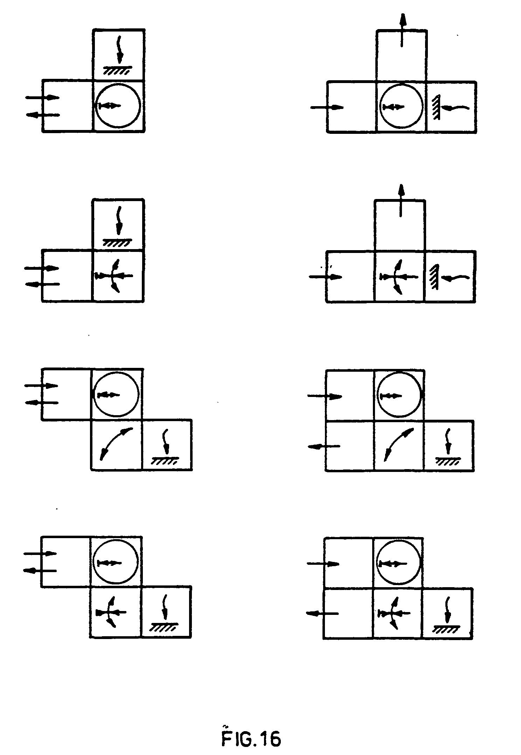

In Fig. 16 sind einige Konfigurationen von Anlagen dargestellt, worin mindestens eine der Kammern eine RAKAK- oder RADK-Kammer ist. Daraus ist ersichtlich, dass sich mit den beiden Kammertypen sowie weiteren bekannten Kammern in höchster Flexibilität, modular beliebige Anlagenkonfigurationen zusammenstellen lassen mit oder ohne Mitintegration des Maskierungskonzeptes gemäss Fig. 5. Das erfindungsgemässe Vorgehen eignet sich insbesondere für die Bearbeitung von magneto-optischen Speicherplatten.

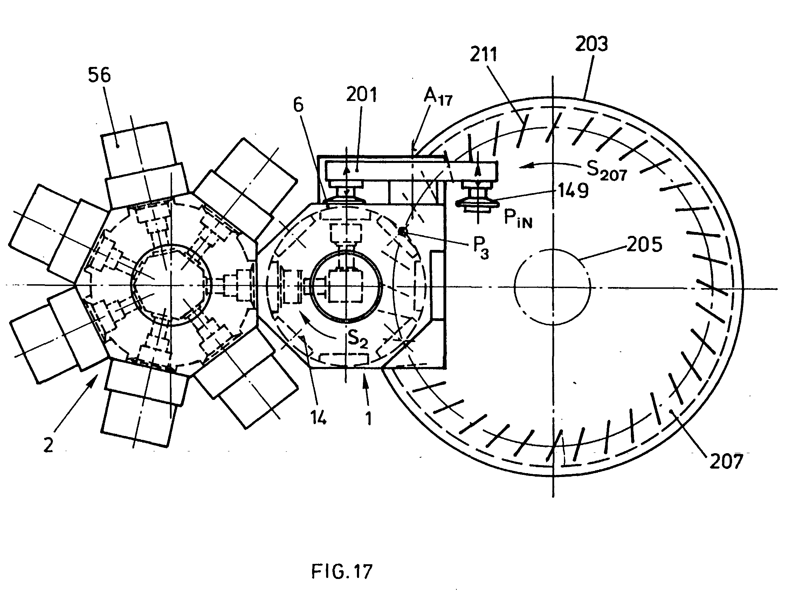

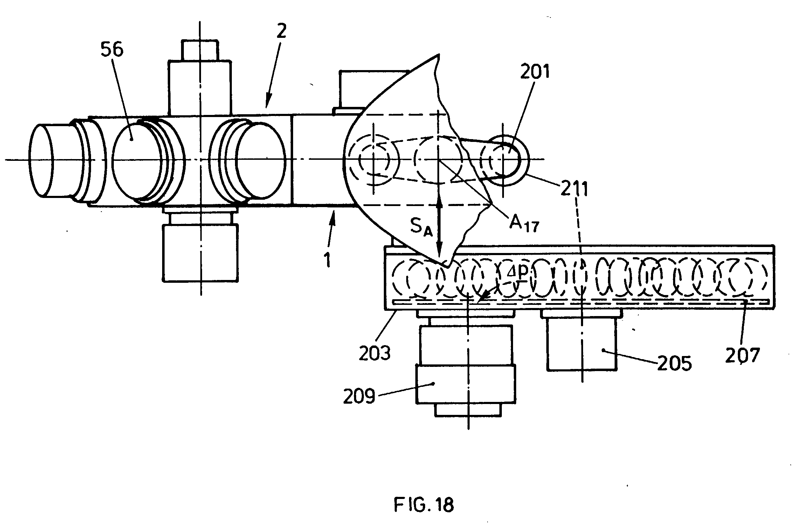

In den Fig. 17 und 18 ist, jeweils in Aufsicht und in Seitenansicht, schematisch, eine weitere bevorzugte Anlagekonfiguration dargestellt. Sie umfasst die Kammer 2, wie sie insbesondere anhand der Fig. 1 und 2 erläutert wurde, sowie die ebenfalls dort beschriebene Kammer 1. Die Oeffnung 6 der Kammer 1, insbesondere aus Fig. 2 ersichtlich, wird durch einen Drehroboterarm 201, analog zu dem in Fig. 14 dargestellten, bedient und ist, um Achse A₁₇, getrieben drehbeweglich. Mittels der axial vor- und rückholbaren Teller 149 werden die scheibenförmigen Substrate in der Position P_{iN}, wie schematisch dargestellt, aufgenommen und durch Drehen des Roboterarmes 201 in die Position an der Oeffnung 6 gebracht. Dort werden sie, wie bereits anhand von Fig. 2 beschrieben wurde, in die Kammer 1 übernommen. Daraufhin dreht das Karussell 14 in Richtung S₂ um ein Drehwinkelinkrement weiter. Das eben eingeführte, scheibenförmige Substrat liegt im Karussell in Position P₃.

Wie insbesondere aus Fig. 18 ersichtlich, ist unterhalb der Kammer 1 eine Entgasungskammer 203 angeordnet, welche einen durch einen zentrischen Antrieb 205 getriebenen Transportdrehteller 207 umfasst. Die Entgasungskammer 203 wird separat von einer Vakuumpumpe 209 gepumpt. In Position P₃ des Substrates gemäss Fig. 17 wird letzteres in Richtung S_{A} gemäss Fig. 18 durch einen nicht dargestellten Transportschieber von der oberen Position in Kammer 1 in die darunterliegende in der Entgasungskammer 203 transportiert. Während das Karussell 14 in Kammer 1 weiterhin stationär bleibt, wird mit dem Antrieb 205 der Transportteller 207 in Kammer 203 in der in Fig. 17 mit S₂₀₇ angegebenen Richtung um ein Winkelinkrement weitergedreht. Dadurch kommt eines der Substrate 211 in die Position unterhalb P₃ zu liegen, welches in der Kammer 203 einen vollständigen Umlauf vollzogen hat.

Mit dem erwähnten Transportschieber wird nun das letzterwähnte Substrat in Richtung S_{A} von der Kammer 203 in Position P₃ in Kammer 1 hochgehoben und nimmt am Karussell 14 denjenigen Platz ein, der eben von einem der Kammer 203 neu zugeführten Substrat belegt war. Daraufhin wird das Karussell 14 in Kammer 1 um ein Drehwinkelinkrement in Richtung S₂ weitergedreht.

Es ist nun ohne weiteres ersichtlich, dass alle Substrate ab der Position P₃ in der Kammer 1 diese Kammer verlassen und während einer langen Zeit in der Entgasungskammer 203 entgast werden, was durch Vorsehen beispielsweise zusätzlicher Heizelemente in dieser Kammer 203 (nicht dargestellt) unterstützt werden kann, bis sie an der erwähnten Position P₃ zurück in Kammer 1 aufgenommen werden und ihrer Bearbeitung zugeführt werden. Dabei wird der Arbeitstakt der Gesamtanlage aber nicht verlangsamt. Von der Kammer 1 werden die Werkstücke, wie beschrieben wurde anhand von Fig. 1 und 2, der Kammer 2 übergeben und dort mittels der beispielsweise sechs dargestellten Bearbeitungsstationen 56 bearbeitet. Durch die Dimension der Entgasungskammer bzw. ihrer Aufnahmekapazität kann die notwendige Entgasungszeit für die jeweilige Anwendung leicht vorgegeben werden.

Während der Uebergabe der scheibenförmigen Werkstükke, Substrate 211, von Kammer 1 in Entgasungskammer 203 kann mit Hilfe des erwähnten Transportschiebers eine jeweilig schleusenartige Abtrennung von Kammer 1 zu Kammer 203 sichergestellt werden. Die Vakuumpumpe 209 stellt sicher, dass Entgasungsprodukte aus der Kammer 203 entfernt werden. Durch sie wird ein Druckgradient in der Kammer 203 hin zur Pumpe 209 sichergestellt, wie gestrichelt bei Δp in Fig. 18 dargestellt.

## Patentansprüche

1. Vakuumkammer mit einer um eine Drehachse (A₁₄) drehbar angetriebenen Werkstücktransporteinrichtung (14), die als Karussell ausgebildet ist und eine Mehrzahl von Werkstückhalterungen (20) trägt, mindestens zwei in der Kammerwand angebrachten, zur Achse (A₁₄) radial angeordneten Oeffnungen (4, 6), auf die die Werkstückhalterungen (20) durch Drehen der Werkstücktransporteinrichtungen (14) ausrichtbar sind, mit einer innerhalb der als Karussell ausgebildeten Werkstücktransporteinrichtung (14) angeordneten Vorschubeinrichtung (29) mit mindestens zwei bezüglich der Drechachse (A₁₄) gesteuert radial ausfahrbaren und rückholbaren Vorschuborganen (30a, 30b), die unabhängig von der Drehbewegung der als Karussell ausgebildeten Werkstücktransporteinrichtung (14) auf je eine Öffnung (4, 6) ausgerichtet sind oder durch eine Drehbewegung um die Drehachse (A₁₄) ausrichtbar sind, wobei jedes Vorschuborgan (30a, 30b) einen eigenen, daran integrierten, linearen Antrieb für die Ausfahr- und Rückholbewegung hat und diese Antriebe voneinander unabhängig sind.

2. Vakuumkammer mit mindestens zwei Oeffnungen (157) und einer Werkstücktransporteinrichtung, mit der mindestens ein in der Kammer befindliches Werkstück selektiv in eine Position im Bereich einer der Oeffnungen (157) bewegbar ist, wobei die Werkstücktransporteinrichtung in der Kammer um eine Drehachse (A) drehbeweglich gelagert ist und mindestens eine Werkstückhalterung (149) für ein Werkstück trägt und wobei für das Drehen der Werkstücktransporteinrichtung ein Drehantrieb (130) und für eine Verschiebung eines Werkstückes bezüglich der Werkstücktransporteinrichtung ein Vorschubantrieb vorgesehen ist, derart, dass die Werkstückhalterung (149) durch Drehen der Transporteinrichtung selektiv gegenüber einer der Oeffnungen (157) positionierbar und ein Werkstück aus dieser Position durch den Vorschubantrieb zur Oeffnung (157) hin bzw. von ihr weg verschiebbar ist, wobei der Vorschubantrieb an der drehbaren Werkstücktransporteinrichtung angeordnet ist und an mindestens einer der Oeffnungen (157b) der Vakuumkammer die Öffnung einer weiteren Vakuumkammer (158b) angeschlossen ist, die selbst mindestens eine weitere Oeffnung und eine Werkstücktransportanordnung aufweist.

3. Vakuumkammer mit mindestens zwei Oeffnungen (157) und einer Werkstücktransporteinrichtung, mit der mindestens zwei in der Kammer befindliche Werkstücke selektiv in jeweils eine radial auf eine der Oeffnungen (157) ausgerichtete Position bewegbar sind, wobei die Werkstücktransporteinrichtung in der Kammer um eine Drehachse (A) drehbeweglich gelagert ist und mindestens zwei Werkstückhalterungen (149) je für ein Werkstück trägt, und weiter mindestens zwei Vorschuborgane vorgesehen sind, welche, radial auf die Oeffnungen ausgerichtet oder ausrichtbar, die Werkstücke bezüglich der Transporteinrichtung mit mindestens einer radialen Bewegungskomponente zur jeweiligen Oeffnung oder umgekehrt verschieben, wobei jedes Vorschuborgan einen von demjenigen des andern Vorschuborgans unabhängigen Vorschubantrieb aufweist und an mindestens einer der Oeffnungen der Vakuumkammer die Öffnung einer weiteren Kammer (158b) angeschlossen ist, die selbst mindestens eine weitere Oeffnung und eine Werkstücktransportanordnung aufweist.

4. Vakuumkammer nach Anspruch 2 oder 3, **dadurch gekennzeichnet, dass** die weitere Vakuumkammer (158b) nach Anspruch 1 ausgebildet ist.

5. Vakuumkammer nach einem der Ansprüche 1 bis 4, **dadurch gekennzeichnet, dass** der Vorschubantrieb ein linearer Antrieb ist und vorzugsweise relativ zueinander, aneinander bewegte Teile des Antriebes balggekapselt (32b; 153) sind.

6. Vakuumkammer nach einem der Ansprüche 4 oder 5, **dadurch gekennzeichnet, dass** die Vorschuborgane in der weiteren Vakuumkammer (1) bezüglich der Drehachse (A₁₄) drehfest gelagert sind.

7. Vakuumkammer nach einem der Ansprüche 1 bis 6, **dadurch gekennzeichnet, dass** sie, von ihrem Inneren her betrachtet, eine erste Aufnahmeöffnung für zu bearbeitende Werkstücke (6) und eine erste Ausgabeöffnung (4) für bearbeitete Werkstücke aufweist sowie eine zweite Ausgabeöffnung (6) für zu bearbeitende Werkstücke und eine zweite Aufnahmeöffnung (4) für bearbeitete Werkstücke, wobei gegebenenfalls die erste und/oder die zweite Aufnahme- und Ausgabeöffnung zu jeweils einer Oeffnung (4, 6) kombiniert sind, und dass der Transportweg (s₂) der mittels der Werkstückhalterung von der ersten Aufnahmeöffnung (6) zur zweiten Ausgabeöffnung (4) bewegten, zu bearbeitenden Werkstücke (22) länger ist als der Transportweg für bearbeitete Werkstücke von der zweiten Aufnahmeöffnung (4) zur ersten Ausgabeöffnung (6).

8. Vakuumkammer nach einem der Ansprüche 1 bis 7, **dadurch gekennzeichnet, dass** der Vorschubantrieb zu der Drehachse (A₄₄, A₁₄) rechtwinklig auf die Werkstücke wirkt.

9. Vakuumkammer nach einem der Ansprüche 3, bis 8, **dadurch gekennzeichnet, dass** die Werkstückhalterungen (20) mittels der Vorschubantriebe an die Oeffnungsberandung anlegbar sind.

10. Vakuumkammer nach einem der Ansprüche 1 bis 9, **dadurch gekennzeichnet, dass** Dichtungsorgane (66, 68) zum vorzugsweisen vakuumdichten Abdichten zwischen den Werkstückhalterungen (20) und den Oeffnungen vorgesehen sind.

11. Vakuumkammer nach einem der Ansprüche 1 bis 10, **dadurch gekennzeichnet, dass** an den Werkstückhalterungen (20, 52) vorzugsweise gesteuerte Halteorgane (26, 64) für ein Werkstück (22) vorgesehen sind.

12. Vakuumkammer nach einem der Ansprüche 1 bis 11, **dadurch gekennzeichnet, dass** mindestens ein Teil (4, 6, 54) der Oeffnungen durch Wirkung der Werkstücktransporteinrichtung und/oder der Vorschubantriebe dicht, vorzugsweise vakuumdicht, schliessbar ist.

13. Vakuumkammeranordnung mit einer Kammer nach einem der Ansprüche 1 bis 12, **dadurch gekennzeichnet, dass** die Kammer (1) mindestens drei Aussenöffnungen aufweist, wovon mindestens eine mit einer Zwischenspeicherkammer (203) kommuniziert, und ein Zweiweg-Transportorgan (201) vorgesehen ist, um jeweils mindestens ein Werkstück aus der Kammer (1) in die Zwischenspeicherkammer (203) bzw. umgekehrt zu fördern.

14. Vakuumkammeranordnung nach Anspruch 13, **dadurch gekennzeichnet, dass** in der Zwischenspeicherkammer (203) ein Umlauf-Transportorgan (207) vorgesehen ist, womit jeweils das mindestens eine eingeförderte Werkstück durch die Zwischenspeicherkammer (203) zu seiner Rückförderung in die Kammer (1) bewegt wird.

15. Vakuumkammeranordnung nach einem der Ansprüche 13 oder 14, **dadurch gekennzeichnet, dass** die Zwischenspeicherkammer (203) als Entgasungskammer für die Werkstücke ausgebildet ist.

16. Vakuumkammeranordnung nach einem der Ansprüche 13 bis 15, **dadurch gekennzeichnet, dass** die mindestens eine Aussenöffnung und die Transportbewegung des Zweiweg-Transportorgans (201) im wesentlichen parallel zur Drehachse (A₁₄) ausgerichtet sind und vorzugsweise ein Umlauf-Transportorgan (207) in der Zwischenspeicherkammer (203) eine zur Achse (A₁₄) im wesentlichen rechtwinklige Förderebene für Werkstücke definiert.

17. Vakuumkammer bzw. Vakuumkammeranordnung nach einem der Ansprüche 1 bis 16, **dadurch gekennzeichnet, dass** mindestens eine weitere Kammer des Typus Schleusenkammer (6), Bearbeitungskammer (56), Transportkammer (158) an einer Aussenöffnung der Kammer vorgesehen ist.

18. Transportverfahren für Werkstücke zwischen einer evakuierbaren ersten Kammer, bei der mindestens zwei Werkstücke mittels eines ersten Organs um eine Drehachse in einer Drehebene gedreht werden und mit mindestens einer bezüglich der Drehachse radialen Bewegungskomponente verschoben werden, und einer zweiten Kammer, in welcher Werkstücke weitertransportiert werden, **dadurch gekennzeichnet, dass** die Werkstücke in der ersten Kammer unabhängig voneinander, aus dem Zentrum ihrer Drehbewegung heraus realisiert, gesteuert verschoben werden und durch diese voneinander unabhängige Verschiebung der zweiten Kammer zugeführt oder von ihr rückgeholt werden.

19. Verfahren nach Anspruch 18, **dadurch gekennzeichnet, dass** die Werkstücke linear verschoben werden.

20. Verfahren nach einem der Ansprüche 18 oder 19, **dadurch gekennzeichnet, dass** die Werkstücke mittels eines um die Drehachse drehgetriebenen Organs gedreht und mit diesem Organ auch verschoben werden oder mittels eines ersten Organs um das Zentrum gedreht werden und mittels eines zweiten verschoben werden, wobei das zweite um das Zentrum unabhängig drehbar ist oder drehfest ist.

21. Transportverfahren für Werkstücke in einer evakuierbaren Kammer, bei der mindestens zwei Werkstücke mittels eines ersten Organs um eine Drehachse in einer Drehebene gedreht werden und mit mindestens einer bezüglich der Drehachse radialen Bewegungskomponente verschoben werden, **dadurch gekennzeichnet, dass** die Werkstücke mittels eines zweiten Organs, das unabhängig vom ersten um die Achse drehbar ist oder diesbezüglich drehfest ist, aus dem Zentrum ihrer Drehbewegung heraus realisiert, unabhängig voneinander verschoben werden.

22. Verfahren nach Anspruch 21, **dadurch gekennzeichnet, dass** die Werkstücke linear verschoben werden.

23. Verfahren nach einem der Ansprüche 18 bis 22, **dadurch gekennzeichnet, dass** mit der Verschiebung der Werkstücke eine jeweilige Öffnung an der Kammer dicht, vorzugsweise vakuumdicht, verschlossen wird.

## Claims

1. Vacuum chamber including a device (14) for transporting parts, said device is driven in rotation around a spin axis (A₁₄) and is constituted by a carrousel and bearing a plurality of part supports (20), at least two openings (4, 6) provided in the wall of the chamber and placed radially with respect to the axis (A₁₄) and towards which the parts supports (20) can be orientated via the rotation of the part transport devices (14), an advance device (29) placed inside the part transport device (14) constituted by a carrousel and which includes at least two advance elements (30a, 30b) able to be extended and retracted radially in a controlled way with respect to the spin axis (A₁₄) and which are orientated towards a particular opening (4, 6) independently of the rotation movement of the part transport device (14) constituted by a carrousel or which can be orientated by a movement of rotation around the spin axis (A₁₄), each advance element (30a, 30b) possessing an integrated linear drive for the extension and retraction movement, these drives being independent of one another.

2. Vacuum chamber having at least two openings (157) and a part transport device by means of which at least one part located in the chamber can be selectively placed in a position in the region of one of the openings (157), the part transport device being mounted mobile in rotation around a spin axis (A) inside the chamber and bearing at least one part support (149) for one part, and a rotation drive (130) being provided for rotating the part transport device and an advance drive being provided for a translation of a part with respect to the part transport device so that the part support (149) can be selectively positioned opposite one of the openings (157) via a rotation of the transport device and that from this position a part can be brought closer to and moved away from the opening (157) in a translation movement by the advance drive, the latter being placed on the rotating part transport device and at least one of the openings (157b) of the vacuum chamber being connected to the opening of another vacuum chamber (158b) itself having at least one other opening and a part transport device.

3. Vacuum chamber including at least two openings (157) and a part transport device with the aid of which at least two parts located in the chamber are able to be selectively placed respectively in a position orientated radially towards one of the openings (157), the part transport device being mounted mobile in rotation around a spin axis (A) inside the chamber and bearing at least two part supports (149) for one part each, wherein in addition at least two advance elements are provided which are orientated or can be orientated radially towards the openings and move the parts in translation with respect to the transport device with at least one component with a radial movement in the direction of the corresponding opening or in the opposite direction and each advance element has an advance drive independent from that of the other advance element and at least one of the openings of the vacuum chamber is connected to the opening of another chamber (158b) having at least one other opening and a part transport device.

4. Vacuum chamber according to claim 2 or 3, **characterised in that** the other vacuum chamber (158b) is embodied according to claim 1.

5. Vacuum chamber according to one of claims 1 to 4, **characterised in that** the advance drive is a linear drive and the portions of the drive which are moved with respect to each other, namely one along the other, are preferably contained in a pair of bellows (32b ; 153).

6. vacuum chamber according to claim 4 or 5, **characterised in that** the advance elements contained in the other vacuum chamber (1) are mounted so as to be rendered integral in rotation with respect to the spin axis (A₁₄).

7. Vacuum chamber according to one of claims 1 to 6, **characterised in that** seen from the inside it has a first opening for receiving parts (6) to be worked and a first opening (4) for unloading the worked parts, as well as a second opening (6) for unloading the parts to be worked and a second opening (4) for receiving the worked parts, the first and/or the second receiving and unloading openings possibly being combined so as to form an opening (4, 6), and **in that** the transport path (s₂) of the parts (22) to be worked, which are moved with the aid of the part support from the first receiving opening (6) to the second unloading opening (4), is longer than the transport path for the worked parts starting from the second receiving opening (4) to the first unloading opening (6).

8. Vacuum chamber according to one of claims 1 to 7, **characterised in that** the advance drive acts on the parts in a direction perpendicular to the spin axis (A₄₄, A₁₄).

9. Vacuum chamber according to one of claims 3 to 8, **characterised in that** the part supports (20) can be applied against the edge of the opening with the aid of the advance drives.

10. Vacuum chamber according to one of claims 1 to 9, **characterised in that** sealing elements (66, 68) are provided so as to preferably form a vacuum seal between the part supports (20) and the openings.

11. Vacuum chamber according to one of claims 1 to 10, **characterised in that** preferably controlled fixing elements (26, 64) for a part (22) are provided on the part supports (20, 52).

12. Vacuum chamber according to one of claims 1 to 11, **characterised in that** at least one portion (4, 6, 54) of the openings can be closed with a seal and preferably with a vacuum seal by the action of the part transport device and/or the advance drives.

13. Vacuum chamber device including a chamber according to one of claims 1 to 12, **characterised in that** the chamber (1) has at least three external openings, at least one of said openings communicating with a buffer chamber (203), a bidirectional transport element (201) being provided to transport at least one part from the chamber (1) into the buffer chamber (203) or vice versa.

14. Vacuum chamber device according to claim 13, **characterised in that** provided in the buffer chamber (203) is a circulating transport element (207) by means of which at least one part introduced is driven through the buffer chamber (203) so as to be sent back into the chamber (1).

15. Vacuum chamber device according to claim 13 or 14, **characterised in that** the buffer chamber (203) constitutes a chamber for degassing the parts.

16. Vacuum chamber device according to one of claims 13 to 15, **characterised in that** said external opening(s) and the transport movement of the bidirectional transport element (201) are orientated approximately parallel to the spin axis (A₁₄) and a circulating transport element (207) provided in the buffer chamber (203) preferably defines a part transport plane approximately perpendicular to the axis (A₁₄).

17. Vacuum chamber or vacuum chamber device according to one of claims 1 to 16, **characterised in that** at least one other chamber of the type lock chamber (6), working chamber (56), transport chamber (158) is provided near an external opening of the chamber.

18. Method for transporting parts between a first chamber which can be evacuated and in which at least two parts are rotated in a plane of rotation around a spin axis with the aid of a first element and are moved in translation with at least one radial movement component with respect to the spin axis, and a second chamber in which parts are again transported, **characterised in that** in the first chamber the parts are moved in translation independently of each other, in a controlled way, departing from the centre of their rotation movement and are routed to the second chamber or retracted from this chamber by this translation being independent of each other.

19. Method according to claim 18, **characterised in that** the parts are moved in linear translation.

20. Method according to claim 18 or 19, **characterised in that** the parts are rotated with the aid of an element driven in rotation around the spin axis and are also moved in translation with this element or are rotated around the centre with the aid of a first element and moved in translation with the aid of a second element, the latter being able to rotate independently around the centre or being integral on rotation.

21. Method for transporting parts into a chamber which can be evacuated and in which at least two parts are rotated around a spin axis in a rotation plane with the aid of a first element and are moved in translation with at least one radial movement component with respect to the spin axis, **characterised in that** the parts are moved in translation independently of one another departing from the centre of their rotation movement with the aid of a second element which can be rotated relative to the axis independently of the first element or which is not rotatable relative thereto.

22. Method according to claim 21, **characterised in that** the parts are moved in linear translation.

23. Method according to one of claims 18 to 22, **characterised in that**, under the effect of the translation of the parts, the opening of the chamber concerned is sealed with a seal, preferably a vacuum seal.

## Revendications

1. Chambre à vide comprenant un dispositif de transport de pièces (14) qui est entraîné en rotation autour d'un axe de rotation (A₁₄), qui est conçu comme un carrousel et qui porte plusieurs porte-pièce (20) ; au moins deux ouvertures (4, 6) qui sont prévues dans la paroi de la chambre, radialement par rapport à l'axe (A₁₄), et dans l'alignement desquelles les porte-pièce (20) peuvent être amenés grâce à une rotation du dispositif de transport de pièces (14) ; et un dispositif d'avance (29) qui est disposé à l'intérieur du dispositif de transport de pièces (14) conçu comme un carrousel et qui comporte au moins deux organes d'avance (30a, 30b), lesquels organes d'avance (30a, 30b) sont aptes à être déployés et rétractés radialement, de manière commandée, par rapport à l'axe de rotation (A₁₄) et sont amenés dans l'alignement d'une ouverture respective (4, 6) indépendamment de la rotation du dispositif de transport de pièces (14) conçu comme un carrousel, ou sont aptes à être alignés grâce à une rotation autour de l'axe de rotation (A₁₄), chaque organe d'avance (30a, 30b) ayant son propre entraînement linéaire intégré destiné au mouvement de déploiement et de rétraction, et les entraînements étant indépendants l'un de l'autre.

2. Chambre à vide comportant au moins deux ouvertures (157) et un dispositif de transport de pièces grâce auquel au moins une pièce qui se trouve dans la chambre peut être amenée sélectivement dans une position située dans la zone de l'une des ouvertures (157), étant précisé que le dispositif de transport de pièces est monté dans la chambre pour pouvoir tourner autour d'un axe de rotation (A) et porte au moins un porte-pièce (149) pour une pièce, et qu'il est prévu un entraînement en rotation (130) pour faire tourner le dispositif de transport de pièces, et un entraînement d'avance pour déplacer une pièce par rapport au dispositif de transport de pièces, de telle sorte que le porte-pièce (149) puisse être positionné sélectivement en face de l'une des ouvertures (157) grâce à la rotation du dispositif de transport de pièces et qu'une pièce, à partir de cette position, puisse être amenée par l'entraînement d'avance vers cette ouverture (157) ou éloignée de celle-ci, l'entraînement d'avance étant disposé sur le dispositif de transport de pièces rotatif et l'ouverture d'une autre chambre à vide (158b) étant reliée à l'une au moins des ouvertures (157b) de la chambre à vide, laquelle autre chambre (158b) présente elle-même au moins une autre ouverture et un dispositif de transport de pièces.

3. Chambre à vide comportant au moins deux ouvertures (157) et un dispositif de transport de pièces grâce auquel au moins deux pièces qui se trouvent dans la chambre peuvent être amenées sélectivement dans une position située radialement dans l'alignement de l'une des ouvertures (157), étant précisé que le dispositif de transport de pièces est monté dans la chambre pour pouvoir tourner autour d'un axe de rotation (A) et porte au moins deux porte-pièce (149) pour des pièces respectives, et qu'il est également prévu au moins deux organes d'avance qui, situés ou aptes à être amenés, radialement, dans l'alignement des ouvertures, déplacent les pièces par rapport au dispositif de transport avec au moins une composante de mouvement radiale vers l'ouverture correspondante, ou inversement, étant précisé enfin que chaque organe d'avance comporte un entraînement d'avance indépendant de celui de l'autre organe d'avance, et que l'ouverture d'une autre chambre (158b) est reliée à l'une au moins des ouvertures de la chambre à vide, laquelle autre chambre présente elle-même au moins une autre ouverture et un dispositif de transport de pièces.

4. Chambre à vide selon la revendication 2 ou 3, **caractérisée en ce que** l'autre chambre à vide (158b) est conçue selon la revendication 1.

5. Chambre à vide selon l'une des revendications 1 à 4, **caractérisé en ce que** l'entraînement d'avance est un entraînement linéaire et, de préférence, des éléments de l'entraînement déplacés les uns par rapport aux autres, les uns contre les autres, sont enfermés dans un soufflet (32b; 153).

6. Chambre à vide selon la revendication 4 ou 5, **caractérisée en ce que** les organes d'avance sont montés dans l'autre chambre à vide (1) en étant fixes en rotation par rapport à l'axe de rotation (A₁₄).

7. Chambre à vide selon l'une des revendications 1 à 6, **caractérisée en ce que** vue de l'intérieur, elle présente une première ouverture de réception pour les pièces à traiter (6) et une première ouverture de sortie (4) pour les pièces traitées, ainsi qu'une seconde ouverture de sortie (6) pour les pièces à traiter et une seconde ouverture de réception (4) pour les pièces traitées, étant précisé que le cas échéant, la première et/ou la seconde ouverture de réception et de sortie sont combinées pour former une ouverture (4, 6), et **en ce que** la course de transport (s₂) des pièces à traiter (22) déplacées à l'aide du porte-pièce de la première ouverture de réception (6) jusqu'à la seconde ouverture de sortie (4) est plus longue que la course de transport pour les pièces traitées, de la seconde ouverture de réception (4) jusqu'à la première ouverture de sortie (6).

8. Chambre à vide selon l'une des revendications 1 à 7, **caractérisée en ce que** l'entraînement d'avance agit sur les pièces à angle droit par rapport à l'axe de rotation (A₄₄, A₁₄).

9. Chambre à vide selon l'une des revendications 3 à 8. **caractérisée en ce que** les porte-pièce (20) sont aptes à être appliqués contre le bord des ouvertures à l'aide des entraînements d'avance.

10. Chambre à vide selon l'une des revendications 1 à 9, **caractérisée en ce qu'**il est prévu des organes d'étanchéité (66, 68) pour réaliser de préférence une étanchéité au vide entre les porte-pièce (20) et les ouvertures.

11. Chambre à vide selon l'une des revendications 1 à 10, **caractérisée en ce qu'**il est prévu sur les porte-pièce (20, 52), pour une pièce (22), des organes de fixation (26, 64) de préférence commandés.

12. Chambre à vide selon l'une des revendications 1 à 11, **caractérisée en ce qu'**une partie au moins (4, 6, 54) des ouvertures peuvent être fermées de manière étanche, de préférence de manière étanche au vide, grâce à l'action du dispositif de transport de pièces et/ou des entraînements d'avance.

13. Dispositif à chambre à vide comprenant une chambre selon l'une des revendications 1 à 12, **caractérisé en ce que** la chambre (1) comporte au moins trois ouvertures extérieures dont une, au moins, communique avec une chambre de stockage intermédiaire (203), et il est prévu un organe de transport bidirectionnel (201) pour extraire au moins une pièce de la chambre (1) et l'introduire dans la chambre intermédiaire (203) et inversement.

14. Dispositif à chambre à vide selon la revendication 13, **caractérisé en ce qu'**il est prévu dans la chambre de stockage intermédiaire (203) un organe de transport circulaire (207) à l'aide duquel la ou les pièces introduites traversent ladite chambre intermédiaire (203) en vue d'être ramenées dans la chambre (1).

15. Dispositif à chambre à vide selon la revendication 13 ou 14, **caractérisé en ce que** la chambre de stockage intermédiaire (203) est conçue comme une chambre de dégagement de gaz pour les pièces.

16. Dispositif à chambre à vide selon l'une des revendications 13 à 15, **caractérisé en ce que** la ou les ouvertures extérieures et le mouvement de transport de l'organe de transport bidirectionnel (201) sont sensiblement parallèles à l'axe de rotation (A₁₄), et un organe de transport circulaire (207) définit de préférence, dans la chambre de stockage intermédiaire (203), un plan de transport pour les pièces qui est situé sensiblement à angle droit par rapport à l'axe (A₁₄).

17. Chambre à vide et dispositif à chambre à vide selon l'une des revendications 1 à 16, **caractérisés en ce qu'**il est prévu au niveau d'une ouverture extérieure de la chambre au moins une autre chambre du type sas (6), chambre de traitement (56), chambre de transport (158).

18. Procédé de transport pour des pièces entre une première chambre dans laquelle on peut faire le vide et dans laquelle au moins deux pièces tournent dans un plan de rotation autour d'un axe de rotation grâce à un premier organe et sont déplacées avec au moins une composante de mouvement radiale par rapport à l'axe de rotation, et une seconde chambre dans laquelle les pièces sont amenées, **caractérisé en ce que** les pièces qui se trouvent dans la première chambre sont déplacées de manière commandée, indépendamment les unes des autres, hors du centre de leur mouvement de rotation, et sont amenées dans la seconde chambre ou extraites de celle-ci grâce à ce déplacement indépendant.

19. Procédé selon la revendication 18, **caractérisé en ce que** les pièces sont déplacées linéairement.

20. Procédé selon la revendication 18 ou 19, **caractérisé en ce que** les pièces tournent grâce à un organe entraîné en rotation autour de l'axe de rotation et sont également déplacées avec cet organe, ou tournent grâce à un premier organe autour du centre et sont déplacées à l'aide d'un second organe, lequel est apte à tourner autour du centre, indépendamment, ou est fixe en rotation.

21. Procédé de transport pour des pièces dans une chambre dans laquelle on peut faire le vide et dans laquelle au moins deux pièces tournent dans un plan de rotation autour d'un axe de rotation grâce à un premier organe et sont déplacées avec au moins une composante de mouvement radiale par rapport à l'axe de rotation, **caractérisé en ce que** les pièces sont déplacées hors du centre de leur mouvement de rotation, indépendamment les unes des autres, grâce à un second organe qui est apte à tourner autour de l'axe indépendamment du premier organe ou qui est fixe en rotation par rapport à l'axe.

22. Procédé selon la revendication 21, **caractérisé en ce que** les pièces sont déplacées linéairement.

23. Procédé selon l'une des revendications 18 à 22, **caractérisé en ce que**, avec le déplacement des pièces, une ouverture de la chambre est fermée de manière étanche, de préférence de manière étanche au vide.
